# EUROPÄISCHE PATENTSCHRIFT

(11) **EP 2 935 500 B1**
(45) Veröffentlichungstag und Bekanntmachung des Hinweises auf die Patenterteilung: **18.11.2020**
(21) Anmeldenummer: 13802339.5
(22) Anmeldetag: 05.12.2013
(51) Int. Cl.: C09J 7/22, C09J 7/29, C09J 7/40, B32B 27/14, B32B 27/32, H01L 23/26, H01L 23/31

(54) **GETTERMATERIAL ENTHALTENDES KLEBEBAND**
ADHESIVE TAPE CONTAINING GETTER MATERIAL
BANDE ADHÉSIVE CONTENANT UN MATÉRIAU GETTER

(30) Priorität: 21.12.2012 DE 102012224310
(43) Veröffentlichungstag der Anmeldung: 28.10.2015
(73) Patentinhaber: tesa SE, 22848 Norderstedt (DE)
(72) Erfinder: KEITE-TELGENBÜSCHER, Klaus, 22529 Hamburg (DE); ELLINGER, Jan, 20255 Hamburg (DE); GRÜNAUER, Judith, 22117 Hamburg (DE); PETERSEN, Anika, 24598 Heidmühlen (DE)
(86) Internationale Anmeldenummer: PCT/EP2013/075639
(87) Internationale Veröffentlichungsnummer: WO 2014/095387

(56) Entgegenhaltungen:
- EP-A2- 0 835 915
- EP-A2- 1 383 182
- WO-A1-2005/037916
- US-A1- 2009 022 967
- Anonymous: "Pressure-sensitive adhesive", Wikipedia - The Free Encyclopedia, 13 February 2018 (2018-02-13), pages 1-4, XP055481253, Retrieved from the Internet: URL:https://en.wikipedia.org/wiki/Pressure -sensitive_adhesive [retrieved on 2018-06-05]

## Beschreibung

Die vorliegende Erfindung betrifft das technische Gebiet der Verkapselungsmaterialien zum Schutz elektronischer Anordnungen. Es wird ein für diesen Zweck geeignetes Klebeband mit verbesserter Schutzfunktion insbesondere gegenüber permeationsfähigen Substanzen vorgeschlagen.

Optoelektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen davon. Die entsprechenden Produkte sind je nach gewünschter Anwendung starr oder flexibel ausgebildet, wobei eine zunehmende Nachfrage nach flexiblen Anordnungen besteht. Die Herstellung derartiger Anordnungen erfolgt häufig durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie beispielsweise Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet. Die Strukturierung erfolgt in der Regel durch Masken.

Als Beispiele für bereits kommerziell erhältliche oder in ihrem Marktpotential interessante optoelektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, ferner Elektrolumineszenzlampen, Licht emittierende elektrochemische Zellen (LEECs), organische Solarzellen wie Farbstoff- oder Polymersolarzellen, anorganische Solarzellen, insbesondere Dünnschichtsolarzellen, zum Beispiel auf der Basis von Silizium, Germanium, Kupfer, Indium und Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von optoelektronischen Anordnungen auf dem Gebiet der anorganischen und organischen Optoelektronik, ganz besonders der organischen Optoelektronik, ist ein Schutz der darin enthaltenen Komponenten vor Permeaten zu sehen. Als Permeate werden dabei in der Regel gasförmige oder flüssige Stoffe angesehen, die in einen Festkörper eindringen und diesen gegebenenfalls durchdringen beziehungsweise durchwandern. Dementsprechend können viele niedermolekulare organische oder anorganische Verbindungen Permeate sein, wobei im vorliegend beschriebenen Zusammenhang Wasserdampf und Sauerstoff von besonderer Bedeutung sind.

Eine Vielzahl von optoelektronischen Anordnungen - besonders bei Verwendung von organischen Materialien - ist sowohl gegen Wasserdampf als auch gegen Sauerstoff empfindlich. Während der Lebensdauer der elektronischen Anordnungen ist deshalb ein Schutz durch eine Verkapselung erforderlich, da andernfalls die Leistung über den Anwendungszeitraum nachlässt. Bei mangelhaftem Schutz können sich beispielsweise durch Oxidations- oder Hydrolyseprozesse bei Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kurzer Zeit drastisch verringern.

Auf dem Gebiet der anorganischen und insbesondere der organischen Optoelektronik gibt es daher einen hohen Bedarf für flexible Klebelösungen, die eine Barriere für Permeate wie Sauerstoff und/oder Wasserdampf darstellen. Im Stand der Technik sind bereits einige Ansätze für derartige Klebelösungen zu finden.

So werden häufiger Flüssigklebstoffe auf Basis von Epoxiden als Barriereklebemassen verwendet, wie sie beispielsweise in WO 98/21287 A1, US 4,051,195 und US 4,552,604 beschrieben sind. Ihr Haupteinsatzgebiet sind Randverklebungen starrer Anordnungen, aber auch mäßig flexibler Anordnungen. Die Aushärtung erfolgt thermisch oder mittels UV-Strahlung.

Der Einsatz dieser flüssigen Klebstoffe bringt allerdings auch eine Reihe von unerwünschten Effekten mit sich. So können niedermolekulare Bestandteile (VOCs - volatile organic compounds) die empfindlichen elektronischen Strukturen der Anordnung schädigen und die Produktion erschweren. Der Klebstoff muss darüber hinaus aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess. Im anschließend erforderlichen Laminationsschritt kann aufgrund der geringen Viskosität das Erreichen einer definierten Schichtdicke und Verklebungsbreite erschwert sein.

Eine Alternative ist der Einsatz von Haft- oder Heißschmelzklebern zur Versiegelung von optoelektronischen Aufbauten. Unter den Haftklebemassen werden dabei bevorzugt solche eingesetzt, die nach der Verklebung durch eingebrachte Energie (zum Beispiel aktinische Strahlung oder Wärme) vernetzbar sind. Derartige Massen werden beispielsweise in US 2006/0100299 A1 und WO 2007/087281 A1 beschrieben. Ihr Vorteil liegt insbesondere darin, dass durch die Vernetzung die Barrierewirkung der Klebemassen verbessert werden kann.

Auch die Verwendung von Heißschmelzklebemassen ist im Stand der Technik bekannt. Vielfach werden hier Copolymere des Ethylens eingesetzt, zum Beispiel Ethylen-Ethylacetat (EEA), Ethylen-Acrylsäure-Copolymer (EAA), Ethylen-Butylacrylat (EBA) oder Ethylen-Methylacrylat (EMA). Insbesondere für auf Siliziumwafern basierende Solarzellenmodule werden in der Regel vernetzende Ethylen-Vinylacetat-(EVA)-Copolymere eingesetzt. Die Vernetzung findet während des Versiegelungsprozesses unter Druck und bei Temperaturen oberhalb von etwa 120° C statt. Dieser Prozess ist für viele auf organischen Halbleitern basierende oder in Dünnschichtverfahren hergestellte optoelektronische Aufbauten aufgrund der hohen Temperaturen und der mechanischen Belastung durch den Druck nachteilig.

Heißschmelzklebemassen auf der Basis von Blockcopolymeren oder funktionalisierten Polymeren sind beispielsweise in WO 2008/036707 A2, WO 2003/002684 A1, JP 2005-298703 A und US 2004/0216778 A1 beschrieben. Ein Vorteil dieser Klebemassen ist, dass durch die Klebstoffe selbst keine oder nur sehr wenig Substanz in den zu verkapselnden Aufbau eingebracht wird, die den Aufbau selbst schädigt, wohingegen dieses Problem vor allem bei reaktiven Flüssigklebersystemen, insbesondere solchen auf Acrylat- oder Epoxidharzbasis, relevant ist. Aufgrund der hohen Anzahl reaktiver Gruppen weisen die letztgenannten Systeme eine relativ hohe Polarität auf, so dass insbesondere Wasser darin enthalten ist. Die Menge liegt in der Regel im Bereich von weniger als 100 ppm bis hin zu mehr als 1 %. Unter anderem auch aus diesem Grund werden solche Flüssigkleber vornehmlich als Randversiegelung der elektronischen Anordnungen eingesetzt, wobei sie nicht in direktem Kontakt mit den aktiven elektronischen Materialien stehen.

Eine weitere Möglichkeit, der Problematik eingeschleppter Permeate zu begegnen, besteht darin, zusätzlich noch ein absorbierendes Material - einen sogenannten Getter - innerhalb der Verkapselung einzuschließen, welches aus dem Klebstoff herausdiffundierendes oder hindurchpermeierendes Wasser oder andere Permeate bindet, indem es sie zum Beispiel absorbiert oder adsorbiert. Ein solches Vorgehen wird unter anderem in EP1407818 A1, US 2003/0057574 A1 und in US 2004/0169174 A1 angedeutet. Die Ausstattung eines Klebstoffs mit Permeat-bindenden Substanzen beziehungsweise Eigenschaften wird darüber hinaus beispielsweise in JP 07-169567, WO 98/01910 A1, WO 03/088371 A2, US 2004-0104673 A1, WO 03/065470 A1, JP 04-296381, US 6833668, DE 102008062130 A1, DE 102008060113 A1 und DE 102008047964 A1 beschrieben.

DE 196 46 048 A1 beschreibt ein Verpackungslaminat für Transdermale Therapeutische Systeme, das ein in einer flächenförmigen Schicht dispergiert enthaltenes Trockenmittel umfasst, wobei diese Schicht durch Vermittlung einer kleberbeschichteten Folie auf dem Verpackungslaminat befestigt ist. Das Verpackungslaminat trocknet den Gasraum in der Verpackung.

DE 199 13 761 A1 beschreibt eine flächenförmige Trocknungsvorrichtung zum Trocknen eines umgebenden Gasraums, die eine Matrix mit einem darin enthaltenen Trockenmittel umfasst, wobei die Matrix auch ein Haftklebstoff sein kann.

EP 1 383 182 A2 offenbart ein System zur Verwendung einer Gas sorbierenden Vorrichtung an einer Oberfläche, worin obere und untere bewegliche und im Wesentlichen gasdichte Schutzschichten einen oder mehrere Räume bilden, in denen mindestens eine sorbierende Vorrichtung angebracht ist. Die sorbierende Vorrichtung umfasst mindestens eine Schicht eines Gettermaterials, die auf Stütz- und Sicherungsmitteln aufgebracht ist, welche wiederum mindestens eine Klebeschicht umfassen, die die sorbierende Vorrichtung an der Oberfläche fixieren kann.

Ein grundsätzlicher Nachteil eines Klebstoffs mit darin verteiltem Gettermaterial ist die Beeinträchtigung der Klebeeigenschaften durch das Gettermaterial. So kann dieses Fläche an der Kontaktfläche zum zu verklebenden Substrat einnehmen, die dann nicht mehr für die Verklebung zur Verfügung steht. Darüber hinaus kann das Gettermaterial beim Verkapseln elektronischer Anordnungen in direkten Kontakt mit der Anordnung gelangen und diese aufgrund seiner Reaktivität schädigen.

WO 2009/086095 A2 beschreibt ein Verkapselungssystem, umfassend einen flexiblen Barrierefilm, einen Klebstoff, der zumindest teilweise auf den Barrierefilm aufgebracht ist, und ein Trockenmittel, das zumindest auf einen Teil des Barrierefilms oder des Klebstoffs aufgebracht ist. Nachteilig ist die komplexe Herstellung einer solcherart strukturierten Schicht.

Ferner ist es möglich, besonders permeatarme Rohstoffe einzusetzen oder den Klebstoff bei der Herstellung oder vor der Applikation von permeierenden Substanzen zu befreien, zum Beispiel durch thermische Trocknung, Vakuumtrocknung, Gefriertrocknung oder das Einmischen von Gettern. Nachteilig an derartigen Verfahren sind die lange Trockendauer und die gegebenenfalls hohen oder niedrigen Trocknungstemperaturen, die den Klebstoff schädigen oder chemische Reaktionen, wie zum Beispiel eine Vernetzung, auslösen können. Auch ist der Prozess des Einmischens und späteren Abtrennens der Getter aufwändig.

Werden solche kleberseitigen Maßnahmen zur Verminderung des Eintrags von schädlichen permeierenden Substanzen in den zu schützenden Aufbau getroffen, so ist es notwendig, die hergestellten Eigenschaften bis zur Verwendung des Klebstoffs möglichst uneingeschränkt zu erhalten. So ist es zum Beispiel notwendig, einen besonders wasserfrei hergestellten Klebstoff vor der Wasseraufnahme aus der Umgebung zu schützen.

Diese Aufgabe wird in der Regel durch eine permeationsdichte oder zumindest - hemmende Verpackung der Klebstoffe gelöst. Flüssigklebstoffe werden in der Regel in entsprechende Behälter, zum Beispiel aus Metall, abgefüllt. Klebebänder werden oft in flexible Beutel aus permeationshemmendem Material - zum Beispiel aus Polyethylenfolie oder einem Folienlaminat aus Aluminium und Polyester - eingeschweißt. Auch die Verpackungsmaterialien selbst müssen dabei möglichst frei von Permeaten sein, die zur Füllgutseite hin freigesetzt werden könnten.

Um Schwächen in der Dichtheit der Verpackung entgegenzuwirken oder eingeschlossene Permeate schnell zu binden, wird oft auch ein Getter mit verpackt, zum Beispiel in Gestalt eines mit Silicagel oder Zeolith gefüllten Beutels. Dieser Getter ist in der Regel nicht in direktem Kontakt mit dem Füllgut. Nachteilig ist bei diesem Verfahren insbesondere der erhöhte Verpackungsaufwand.

Ein spezifisches Problem tritt bei der Verpackung von flächigen Klebstoffen, also Klebebändern oder Klebefolien, auf: Werden diese als Zuschnitte gestapelt oder zur Rolle aufgewickelt, wird dabei Gas - beispielsweise Luft - eingeschlossen, das sich nicht im Austausch mit dem weiteren in der Verpackung verbleibenden Gasraum befindet. Enthaltene unerwünschte Permeate, zum Beispiel Wasserdampf, gelangen also nicht zum in der Verpackung befindlichen Gettermaterial und können somit in die Klebemasse übertreten. Darüber hinaus enthalten solche Klebebänder in der Regel ein temporäres Abdeckmaterial, den sogenannten Liner, sowie oft auch ein Trägermaterial. Diese können ebenfalls unerwünschte Permeate enthalten, die insbesondere aufgrund der großen Kontaktfläche mit dem Klebstoff leicht in diesen permeieren können. In die Verpackung eingebrachte Getterbeutel oder -pads können diese Permeate nicht zuverlässig abfangen und binden. Eine vollständige Befreiung der Liner- und Trägermaterialien von den unerwünschten Permeaten, zum Beispiel durch Trocknung, ist langwierig und aufwändig.

Es besteht somit ein anhaltender Bedarf an geeigneten Maßnahmen zum Schutz flächiger Klebemassen vor Permeaten.

Aufgabe der vorliegenden Erfindung ist es daher, eine flächige Klebemasse zur Verfügung zu stellen, die wirksam sowohl vor aus der Umgebung stammenden Permeaten als auch vor beim Laminieren, Aufwickeln, Stapeln oder sonstigen Verarbeitungsschritten eingeschlossenen Permeaten geschützt ist. Dementsprechend soll bei einem Produkt, beispielsweise einem Klebeband, das eine weitgehend permeatfreie Klebeschicht enthält, diese Klebeschicht zumindest für die Zeit der Lagerung und des Transports weiter weitgehend frei von Permeaten gehalten werden.

Die Lösung der Aufgabe beruht auf dem Grundgedanken der vorliegenden Erfindung, mindestens ein Gettermaterial in geeigneter Weise in eine flächige Klebemasse einzuarbeiten.

Ein erster Gegenstand der Erfindung ist daher ein Klebeband, das zumindest die folgenden Schichten in der angegebenen Abfolge enthält:
- eine erste äußere Klebemassenschicht A,
- eine Schicht B, die mindestens ein anorganisches Gettermaterial enthält, und
- eine zweite äußere Klebemassenschicht C;
und dadurch gekennzeichnet ist, dass
die Klebemassenschichten A und C jeweils unabhängig voneinander aus einer Haftklebemasse oder einer aktivierbaren Klebemasse bestehen;
das anorganische Getternaterial ausgewählt ist aus der Gruppe bestehend aus Barium, Calcium, Calciumsulfat, Calciumchlorid, Calciumoxid, Natriumsulfat, Kaliumcarbonat, Kupfersulfat, Magnesiumperchlorat, Magnesiumsulfat, Lithiumchlorid, Kieselsäuren, Zeolithen sowie Mischungen aus zwei oder mehreren der vorstehenden Substanzen; und das anorganische Gettermaterial in der Schicht B partikulär vorliegt und teilweise von einem Matrixmaterial umschlossen ist..

Mit einem derartigen Klebeband lässt sich ein hervorragender Schutz der Klebemassen vor Permeaten ohne wesentliche Beeinträchtigung der klebtechnischen Eigenschaften realisieren.

Insbesondere betrifft der Gegenstand der Erfindung ein Klebeband, das in zur Hauptfläche orthogonaler Abfolge zumindest die folgenden Schichten enthält:
- eine erste äußere Klebemassenschicht A,
- eine Schicht B, die mindestens ein anorganisches Gettermaterial enthält, und
- eine zweite äußere Klebemassenschicht C.

Unter einem "Klebeband" wird ein mit mindestens einem Haftklebstoff oder mindestens einem reaktivierbaren Klebstoff beschichtetes Trägermaterial beziehungsweise ein als Flächengebilde vorliegender Haftklebstoff oder reaktivierbarer Klebstoff von dauerhafter Gestalt verstanden. Ein Klebeband wird erfindungsgemäß als ein Flächengebilde angesehen, also als ein im Wesentlichen in zwei Dimensionen ausgedehntes Gebilde. Bänder mit ausgedehnter Länge und begrenzter Breite, Bandabschnitte, Etiketten, Stanzlinge und dergleichen sind also von der Bezeichnung "Klebeband" mit umfasst. Nicht umfasst sind hingegen ausgehärtete und noch nicht ausgehärtete Flüssigklebstoffe beziehungsweise mit diesen hergestellte Verklebungen.

Unter der "Hauptfläche" wird erfindungsgemäß die Klebebandoberfläche mit der größten Ausdehnung verstanden. Naturgemäß findet sich diese Hauptfläche im erfindungsgemäßen Klebeband zweimal in zueinander paralleler Ausrichtung im Abstand der Ausdehnung in der verbleibenden Dimension. Welche dieser beiden Flächen als "Hauptfläche" angesehen wird, ist erfindungsgemäß beliebig.

"Äußere" Klebemassenschichten bedeutet erfindungsgemäß, dass die Schichten A und C auf jeweils einer Seite des erfindungsgemäßen Klebebandes die äußerste, den Schichtaufbau abschließende Schicht bilden. Ein eventuell auf den Klebemassenschichten aufliegender Releaseliner wird nicht als Bestandteil des erfindungsgemäßen Klebebandes angesehen.

Die Klebemassenschichten A und C bestehen jeweils unabhängig voneinander aus einer Haftklebemasse oder einer aktivierbaren Klebemasse oder insbesondere einer aktivierbaren Haftklebemasse. Besonders bevorzugt bestehen beide Klebemassenschichten A und C aus einer Haftklebemasse oder einer aktivierbaren Klebemasse oder insbesondere einer aktivierbaren Haftklebemasse; in dieser besonders bevorzugten Variante bestehen also beide Klebemassenschichten jeweils aus einer Klebemasse des gleichen Typs. In einer bevorzugten Ausführungsform der Erfindung besteht mindestens eine der Klebemassenschichten A und C aus einer Haftklebemasse. Besonders bevorzugt besteht jede der Klebemassenschichten A und C aus einer Haftklebemasse. Ganz besonders bevorzugt bestehen die Klebemassenschichten A und C aus der gleichen Haftklebemasse.

Als "Haftklebemassen" werden allgemein und erfindungsgemäß Klebemassen bezeichnet, deren abgebundener Film bei Raumtemperatur in trockenem Zustand permanent klebrig und klebfähig bleibt. Haftklebemassen erlauben bereits unter relativ schwachem Andruck eine dauerhafte Verbindung mit dem Haftgrund und können nach Gebrauch im Wesentlichen rückstandsfrei vom Haftgrund wieder abgelöst werden. Die Verklebbarkeit der Klebemassen beruht auf ihren adhäsiven Eigenschaften und die Wiederablösbarkeit auf ihren kohäsiven Eigenschaften.

Erfindungsgemäß können alle dem Fachmann bekannten Haftklebemassen in den Klebemassenschichten A und C eingesetzt werden, also beispielsweise solche auf der Basis von Acrylaten und/oder Methacrylaten, Polyurethanen, Naturkautschuken, Synthesekautschuken; Styrolblockcopolymermassen mit einem Elastomerblock aus ungesättigten oder hydrierten Polydienblöcken wie zum Beispiel Polybutadien, Polyisopren, Copolymeren aus beiden, Polybutylen, insbesondere Polyisobutylen, sowie weiteren, dem Fachmann geläufigen Elastomerblöcken; Polyolefinen, insbesondere Poly-α-olefinen und/oder Polyisobutylenen; Fluorpolymeren und/oder Silikonen. Unter den Begriff "Haftklebemasse" fallen auch weitere Massen, die haftklebende Eigenschaften entsprechend dem "Handbook of Pressure Sensitive Adhesive Technology" von Donatas Satas (Satas & Associates, Warwick 1999) besitzen.

Werden im Rahmen dieser Schrift Haftklebemassen auf Acrylatbasis erwähnt, so seien hiervon auch ohne explizite Erwähnung Haftklebemassen auf Basis von Methacrylaten und auf Basis von Acrylaten und Methacrylaten umfasst, sofern nicht ausdrücklich anders beschrieben. Ebenfalls im Sinne der Erfindung sind Kombinationen und Mischungen mehrerer Basispolymere sowie mit Klebharzen, Füllstoffen, Alterungsschutzmitteln und/oder Vernetzern additivierte Klebemassen einsetzbar, wobei die Aufzählung der Additive nur beispielhaft und nicht einschränkend zu verstehen ist.

Bevorzugt ist die Polymerbasis der Haftklebemassen ausgewählt aus Styrolblockcopolymeren, Polybutylenen, insbesondere Polyisobutylenen, Polyolefinen und Fluorpolymeren sowie Gemischen aus zwei oder mehreren dieser Polymere. Die aufgeführten Polymere zeichnen sich durch eine hohe Permeationsbarriere gegen Wasserdampf sowie einen geringen Gehalt an Wasser aus. Insbesondere ist die Polymerbasis der Haftklebemassen ausgewählt aus Styrolblockcopolymeren und Polyisobutylenen sowie Mischungen dieser Polymere.

Die Haftklebemassenschichten A und C können grundsätzlich sowohl hinsichtlich ihrer Polymerbasis als auch hinsichtlich ihrer sonstigen Zusammensetzung gleich oder verschieden sein.

In einer weiteren bevorzugten Ausführungsform der Erfindung besteht mindestens eine der Klebemassenschichten A und C aus einer aktivierbaren Klebemasse. Besonders bevorzugt besteht jede der Klebemassenschichten A und C aus einer aktivierbaren Klebemasse. Ganz besonders bevorzugt bestehen die Klebemassenschichten A und C aus der gleichen aktivierbaren Klebemasse.

Unter einer "aktivierbaren Klebemasse" wird eine Klebemasse verstanden, die im nicht aktivierten Zustand keine Adhäsion zu einem Substrat im Sinne einer klebenden Verbindung aufbauen kann. Erst durch Energieeintrag oder eine stoffliche Wechselwirkung wird dies möglich. Als aktivierbare Klebemasse können grundsätzlich alle üblichen aktiviert verklebenden Klebemassensysteme zum Einsatz gelangen. Die Aktivierung erfolgt erfindungsgemäß bevorzugt in der Regel über einen Energieeintrag, zum Beispiel und besonders bevorzugt durch aktinische Strahlung oder Wärme (hitzeaktiviert verklebende Klebemassen).

Hitzeaktiviert verklebende Klebemassen lassen sich grundsätzlich in zwei Kategorien einordnen: thermoplastische hitzeaktiviert verklebende Klebemassen (Schmelzklebstoffe) und reaktive hitzeaktiviert verklebende Klebemassen (Reaktivklebstoffe). Ebenfalls umfasst sind solche Klebemassen, die sich beiden Kategorien zuordnen lassen, nämlich reaktive thermoplastische hitzeaktiviert verklebende Klebemassen (reaktive Schmelzklebstoffe).

Thermoplastische Klebemassen basieren auf Polymeren, die bei einem Erwärmen reversibel erweichen und während des Erkaltens wieder erstarren. Als thermoplastische Klebemassen haben sich insbesondere solche auf der Basis von Polyolefinen und Copolymeren von Polyolefinen sowie von deren säuremodifizierten Derivaten, von lonomeren, von thermoplastischen Polyurethanen, von Polyamiden sowie Polyestern und deren Copolymeren und auch von Blockcopolymeren wie Styrol-Blockcopolymeren als vorteilhaft herausgestellt.

Im Gegensatz dazu enthalten reaktive hitzeaktiviert verklebende Klebemassen reaktive Komponenten. Letztere Bestandteile werden auch als "Reaktivharze" bezeichnet, in denen durch das Erwärmen ein Vernetzungsprozess eingeleitet wird, der nach Beenden der Vernetzungsreaktion eine dauerhafte stabile Verbindung gewährleistet. Bevorzugt enthalten derartige Klebemassen auch elastische Komponenten, zum Beispiel synthetische Nitrilkautschuke oder Styrolblockcopolymere. Derartige elastische Komponenten verleihen der hitzeaktiviert verklebenden Klebemasse infolge ihrer hohen Fließviskosität eine auch unter Druck besonders hohe Dimensionsstabilität.

Strahlungsaktivierte Klebemassen basieren ebenfalls auf reaktiven Komponenten. Letztere Bestandteile können zum Beispiel Polymere oder Reaktivharze umfassen, in denen durch die Bestrahlung ein Vernetzungsprozess eingeleitet wird, der nach Beenden der Vernetzungsreaktion eine dauerhafte stabile Verbindung gewährleistet. Bevorzugt enthalten derartige Klebemassen auch elastische Komponenten, wie sie oben ausgeführt sind.

Besonders bevorzugt besteht mindestens eine der Klebemassenschichten A und C aus einer aktivierbaren Haftklebemasse. Ganz besonders bevorzugt besteht jede der Klebemassenschichten A und C aus einer aktivierbaren Haftklebemasse. Insbesondere bestehen die Klebemassenschichten A und C aus der gleichen aktivierbaren Haftklebemasse. Aktivierbare Haftklebemassen zeigen eine Soforthaftung bei Raumtemperatur und werden darüber hinaus in ihrer Verklebungsfestigkeit oder weiteren Eigenschaften durch die Aktivierung verbessert.

Bevorzugt besteht mindestens eine der Klebemassenschichten A und C aus einer aktivierbaren Klebemasse oder einer Haftklebemasse mit reaktiven Komponenten (Reaktivharzen) auf der Basis von Epoxiden, Oxetanen, (Meth)-Acrylaten und/oder modifizierten - beispielsweise mit Maleinsäureanhydrid gepfropften, epoxidierten und/oder sulfonierten - Styrolblockcopolymeren.

Bevorzugt weisen die Klebemasseschichten A und C zum Zeitpunkt der Fertigstellung des erfindungsgemäßen Klebebandes beziehungsweise vor dessen Verwendung, bevor also die bezweckte Aufnahme von Permeat aus den Klebemassen durch das Gettermaterial beginnt, einen Permeatgehalt von weniger als 2000 ppm, besonders bevorzugt von weniger als 800 ppm auf. Die Angabe ppm bezieht sich dabei auf die Relation des enthaltenen Gesamtgewichts an Permeaten zum untersuchten Klebemassegewicht. Der Permeatgehalt kann mittels Gaschromatographie nach VDA 277 bestimmt werden oder im Fall von Wasser nach DIN EN ISO 62 (gravimetrisches Verfahren, Methode 4) oder DIN 53715 (Karl-Fischer-Titration) nach Lagerung des Prüflings über 24 Stunden bei 23°C und 50 % relativer Luftfeuchte. Bei derart geringen Permeatgehalten der Klebemassen wird die Kapazität der Gettermaterialien der Schicht B nicht so stark durch von vornherein in den Klebemassen enthaltene Permeate beansprucht, sondern die Schicht B kann ihre Funktion als Fänger von aus der Umgebung stammenden Permeaten besser erfüllen.

Die Klebemasseschichten A und C weisen bevorzugt eine geringe Permeationsrate für das zu immobilisierende Permeat auf. Im Fall von Wasserdampf als Permeat beträgt die Wasserdampfpermeationsrate (WVTR) bevorzugt jeweils weniger als 50 g/(m^{2*}d), besonders bevorzugt weniger als 25 g/(m^{2*}d), bezogen auf eine Klebemassedicke von 50 µm. Die WVTR wird dabei bei 38°C und 90% relativer Luftfeuchtigkeit nach ASTM F-1249, die Sauerstoffpermeationsrate (OTR) bei 23°C und 50% relativer Luftfeuchtigkeit nach DIN 53380-Teil 3 gemessen.

Durch die geringe Permeationsrate der Klebemasse diffundiert weniger Permeat aus der Umgebung durch die Klebemasse hindurch in die gettermaterialhaltige Schicht, die somit ihre Funktion länger erfüllen oder mit einer geringeren Menge an Gettermaterial ausgerüstet werden kann, was den Materialeinsatz verringert und Kosten spart. Dies trifft insbesondere auf die Zeit des Herstellens eines erfindungsgemäßen Klebebandes zu, in der es noch nicht durch eine Verpackung oder Abdeckung (z.B. Liner) vor aus der Umgebung eindiffundierenden Permeaten geschützt ist.

Zur Optimierung der Eigenschaften können die Klebemassen der Schichten A und C unabhängig voneinander mit einem oder mehreren Additiven wie Klebrigmachern (Harzen), Weichmachern, Füllstoffen, Pigmenten, UV-Absorbern, Lichtschutzmitteln, Alterungsschutzmitteln, Vernetzungsmitteln, Vernetzungspromotoren oder Elastomeren abgemischt sein.

Die Menge beziehungsweise das Flächengewicht der Klebstoffschichten A und C beträgt unabhängig voneinander bevorzugt 1 bis 2000 g/m², stärker bevorzugt 10 bis 100 g/m², wobei unter "Menge" beziehungsweise "Flächengewicht" die Menge beziehungsweise das Flächengewicht nach einer eventuell durchgeführten Entfernung von Wasser und/oder Lösungsmittel verstanden wird.

Das erfindungsgemäße Klebeband enthält zwischen den äußeren Klebemassenschichten A und C eine Schicht B, die mindestens ein anorganisches Gettermaterial enthält. Unter einem "Gettermaterial" wird dabei ein Stoff verstanden, der zur Aufnahme (Sorption) einer oder mehrerer permeationsfähiger Substanz(en) in der Lage ist. Die Sorption der permeationsfähigen Substanz(en) durch das Gettermaterial kann dabei beispielsweise durch Absorption oder Adsorption erfolgen, wobei Adsorption sowohl in Form von Chemisorption als auch von Physisorption auftreten kann. Das Gettermaterial ließe sich daher auch als "Sorbens" oder als "Sorptionsmittel" bezeichnen. Vorzugsweise ist das Gettermaterial mindestens zur Sorption von Wasser befähigt.

Unter einer "permeationsfähigen Substanz" wird eine Substanz verstanden, die als gasförmiger oder flüssiger, gegebenenfalls auch als fester Stoff, in eine der Klebemassen des erfindungsgemäßen Klebebandes eindringen und diese nachfolgend durchdringen kann. Derartige Substanzen wurden vorstehend und werden nachstehend auch als "Permeate" bezeichnet. Die Permeate können aus der Klebemasse selbst oder aus der Umgebung, beispielsweise aus einem im erfindungsgemäßen Klebeband enthaltenen Trägermaterial stammen. Aus der Klebemasse selbst kommen häufig niedermolekulare organische Verbindungen wie Lösemittelreste, Restmonomere, Öle, Harzkomponenten, Weichmacher sowie Wasser. Aus der Umgebung stammen oft Wasser, flüchtige organische Verbindungen (VOCs), niedermolekulare Kohlenwasserstoffe und Sauerstoff. Als "permeationsfähige Substanzen" beziehungsweise "Permeate" werden insbesondere die folgenden Substanzen angesehen:
Acetonitril, 1-Butanol, Chlorbenzol, Chloroform (Trichlormethan), Cyclohexan, Diethylether, 1,4-Dioxan, Eisessig (Essigsäure), Essigsäureanhydrid, Essigsäureethylester (Ethylacetat, Essigester), Essigsäure-n-Butylester (n-Butylacetat), Essigsäure-tert.-butylester (t-Butylacetat), Ethanol, Methanol, n-Hexan, n-Heptan, 3-Hexanon, 2-Propanol (Isopropanol), 3-Methyl-1-butanol (Isoamylalkohol), Methylenchlorid (Dichlormethan), Methylethylketon (Butanon), Methylisobutylketon, Nitromethan (Nitrocarbol), n-Pentan, 2-Pentanon, 3-Pentanon, Petrolether (Leichtbenzin), Benzin, Propanol, Pyridin (Azin), tert-Butylmethylether, Tetrachlorethen (Perchlorethen), Tetrahydrofuran, Toluol, Trichlorethan, Triethylamin, Xylol, Sauerstoff, Methan, Ethan, Propan, Propen, Butan, Buten, Kohlenstoffdioxid, Ozon, Schwefeldioxid, Wasser.

Erfindungsgemäß können auch Mischungen aus zwei oder mehreren Gettermaterialien eingesetzt werden.

Die Gettermaterialien werden ihrer Funktion entsprechend bevorzugt als von Permeaten freie Materialien eingesetzt, zum Beispiel wasserfrei. Es ist erfindungsgemäß jedoch auch möglich, bereits teilweise mit Permeaten komplexierte Materialien zu verwenden, beispielsweise CaSO₄*1/2H₂O (Calciumsulfat-Halbhydrat) oder Kieselsäuren, die per Definition als Verbindungen der allgemeinen Formel (SiO₂)ₘ*nH₂O vorliegen.

Unter "Kieselsäuren" werden, wie vorstehend beschrieben, Verbindungen der allgemeinen Formel (SiO₂)ₘ*nH₂O verstanden. Es handelt sich dabei um durch nasschemische, thermische oder pyrogene Verfahren hergestelltes Siliciumdioxid. Insbesondere sind unter den Kieselsäuren Kieselgele beziehungsweise Silicagele, beispielsweise mit KobaltVerbindungen als Feuchteindikator imprägnierte Kieselgele (Blaugel), und pyrogene Kieselsäuren geeignete Gettermaterialien.

Erfindungsgemäß ist das Gettermaterial ausgewählt aus der Gruppe bestehend aus Barium, Calcium, Calciumsulfat, Calciumchlorid, Calciumoxid, Natriumsulfat, Kaliumcarbonat, Kupfersulfat, Magnesiumperchlorat, Magnesiumsulfat, Lithiumchlorid, Kieselsäuren, unter diesen speziell Kieselgelen und pyrogenen Kieselsäuren, und Zeolithen sowie Mischungen von zwei oder mehreren der vorstehenden Substanzen. Diese Gettermaterialien bieten den Vorteil, dass sie sich leicht in Matrixmaterialien einarbeiten lassen, ein hohes Sorptionsvermögen zeigen und größtenteils regenerierbare Gettermaterialien sind. Darunter werden Substanzen verstanden, die aufgenommene Permeate, beispielsweise Wasser, unter bestimmten Bedingungen wieder abgeben können und dadurch in einen Zustand gelangen, der sie zu erneuter Permeataufnahme befähigt. Dies ermöglicht ein Verfahren, bei dem die Getter-haltige Schicht beziehungsweise das gesamte Klebeband vor dem Inkontaktbringen mit der Klebemasse beziehungsweise dem Verklebungssubstrat von gegebenenfalls bis zu diesem Zeitpunkt aufgenommenen Permeaten weitgehend befreit wird, beispielsweise durch Trocknen. Dadurch steht vorteilhaft bei Verwendung des erfindungsgemäßen Klebebands die volle Getterkapazität zur Verfügung.

Ganz besonders bevorzugt ist das Gettermaterial ausgewählt aus der Gruppe bestehend aus Calciumoxid, Calciumsulfat, Calciumchlorid, pyrogenen Kieselsäuren und Zeolithen sowie Mischungen von zwei oder mehreren der vorstehenden Substanzen. Diese Materialien weisen besonders hohe Kapazitäten für die Aufnahme von Wasser und weiteren Permeaten auf, sind regenerierbar und lassen sich hervorragend handhaben.

Insbesondere ist das Gettermaterial Calcium oder Calciumoxid. Diese Substanzen lassen über eine Änderung ihrer optischen Eigenschaften Rückschlüsse auf den Permeatgehalt der Klebemasse zu, indem sie beispielsweise mit zunehmender Wasseraufnahme eine Änderung von weiß (Calciumoxid) oder metallisch-undurchsichtig (Calcium) zu einem transparenten Erscheinungsbild vollziehen. So lange also noch freie Getterkapazität anhand des optischen Erscheinungsbildes des Gettermaterials erkennbar ist, kann dies als Indiz dafür gelten, dass noch kein oder allenfalls wenig Permeat in der zu schützenden Masse enthalten ist.

Erfindungsgemäß liegt das Gettermaterial in der Schicht B partikulär vor. Darunter wird verstanden, dass das Gettermaterial im Sinne von DIN 53206-1: 1972-08 in Form von Primärteilchen, Aggregaten und Agglomeraten vorliegt.

Die Partikelgröße der Getterpartikel wird wesentlich durch die Anforderungen an die Dicke der die Partikel enthaltenden Schicht oder des gesamten erfindungsgemäßen Klebebandes bestimmt beziehungsweise begrenzt. Als eine obere Grenze für die Partikelgröße können etwa 2000 µm angesehen werden. Bevorzugt beträgt die maximale Partikelgröße des Gettermaterials 100 µm. Unter der "Partikelgröße" wird dabei die maximale Ausdehnung eines Partikels verstanden. Die Bestimmung der Partikelgröße erfolgt bevorzugt mittels Laserbeugung nach ISO 13320 (wobei im Dispersionsschritt Agglomerate dispergiert werden, nicht jedoch Aggregate), aber auch andere dem Fachmann bekannte Verfahren sind grundsätzlich geeignet.

In einer besonders bevorzugten Ausführungsform liegt das Gettermaterial partikulär und nanoskalig vor. Dies bedeutet, dass die maximale Partikelgröße weniger als 500 nm, bevorzugt weniger als 200 nm, insbesondere weniger als 100 nm beträgt.

Erfindungsgemäß liegt das Gettermaterial in der Schicht B partikulär vor und ist teilweise von einem Matrixmaterial umschlossen. Unter einem "Matrixmaterial" wird ein Material verstanden, das vorliegendes partikuläres Gettermaterial, teilweise oder vollständig umhüllt und von dem Material der Klebemassenschichten A und C verschieden ist. Die Ausführungsform mit einem das Gettermaterial umgebenden Matrixmaterial unterscheidet sich somit von einem Aufbau des Klebebandes, in welchem das Material der Klebemassenschichten A und/oder C das Gettermaterial aufgrund der Fließfähigkeit der Klebemassen zumindest teilweise umhüllt, das umhüllende Material allerdings nicht verschieden von dem Material der Klebemassenschichten A und C ist.

In einer vorteilhaften Ausführung ist das Matrixmaterial eine Polymermasse, bevorzugt eine Haftklebemasse, besonders bevorzugt eine aus der Schmelze verarbeitete, thermisch vernetzte Polyacrylathaftklebemasse oder eine photopolymerisierte Polyacrylathaftklebemasse. Dadurch können die Eigenschaften der verschiedenen Haftklebemasseschichten auf deren Aufgabe im Verbund hin optimiert werden. Beispielsweise kann die Haftklebemasse für das Matrixmaterial eine besonders einfache Dispersion des Gettermaterials ermöglichen oder besonders gut für Permeate durchlässig sein, damit diese schnell zum Gettermaterial gelangen.

Besonders vorteilhaft ist eine Ausführung der Haftklebemasse als viskoelastischer Träger, z.B. auf der Basis von aus der Schmelze verarbeiteten, thermisch vernetzbaren Polyacrylaten, wie sie in WO 2008/122489 A1, DE 102008052625 A1 oder DE 102008059050 A1 beschrieben sind, oder auf der Basis photopolymerisierbarer Acrylate, wie sie in US 4,150,170, US 4,181,752, US 4,330,590, US 4,379,201, US 4,391,687 oder EP 0 573 570 B1 beschrieben sind. Mit einer derartigen Ausführung des Klebebandes kann eine sehr hohe Verklebungsleistung erreicht werden.

Die das Gettermaterial enthaltende Schicht B ist bevorzugt 1 µm bis 3000 µm dick. Wird nur eine geringe Aufnahmekapazität benötigt oder soll das Klebeband möglichst flexibel sein, wird eine Dicke von 1 bis 100 µm bevorzugt. Wird eine hohe Aufnahmekapazität benötigt, wird eine Dicke von 500 bis 3000 µm bevorzugt.

Beispielsweise kann das anorganische Gettermaterial in einem Träger, bevorzugt in den Poren eines porösen Trägermaterials, vorliegen. Dabei füllt das Gettermaterial die Poren nicht vollständig aus, sondern ist darin lediglich - zum Beispiel geometrisch - fixiert, so dass das gettergefüllte Trägermaterial sehr gasdurchlässig ist. Dies hat den Vorteil, dass einwandernde Permeate sehr schnell an das Gettermaterial gelangen können und gleichzeitig durch das Trägermaterial eine hohe innere Festigkeit des Schichtverbunds erreicht werden kann. Poröse Trägermaterialien sind auch besonders zur Aufnahme flüssiger Gettermaterialien geeignet.

Als poröses Trägermaterial können beispielsweise textile Flächengebilde, geschlossen- und offenzellige Schäume oder Papiere eingesetzt werden. Besonders bevorzugt ist der poröse Träger mit darin vorliegendem Gettermaterial aber eine extrudierte und verstreckte Folie, z.B. auf Polyolefinbasis, wie sie in EP 0 232 060 A2 beschrieben wird. Demnach wird ein solcher gasdurchlässiger, poröser Film im Wesentlichen in folgenden Schritten hergestellt:
a) Mischen eines Polymerharzes und eines anorganischen Gettermaterials,
b) Formen eines Films aus der Mischung und
c) Strecken des erhaltenen Films zur Ausbildung der Porosität.

Durch die Auswahl eines Polyolefins als Polymerharz ergibt sich aufgrund der Polaritätsunterschiede zum anorganischen Gettermaterial nur eine schwache Verankerung zwischen den beiden Materialien. Während der Verstreckung wird diese Verbindung zumindest teilweise gelöst, so dass um die dispers verteilten Getterteilchen Poren entstehen, die sich durch eine besonders gute Zugänglichkeit des Gettermaterials für Permeate auszeichnen. Das Gettermaterial liegt also nach dem Verstrecken nicht mehr vollständig von Matrixmaterial umhüllt vor. Durch die Wahl einer Folie als Trägermaterial ergibt sich zudem vorteilhaft eine gute Stanz- und Applizierbarkeit des Aufbaus. Bevorzugt weist die verstreckte, mit anorganischem Gettermaterial gefüllte Folie eine Dicke von weniger als 10 µm, besonders bevorzugt von weniger als 5 µm auf. Dies erlaubt vorteilhaft die Ausbildung einer höheren Flexibilität des erfindungsgemäßen Klebebandes.

Unter textilem Flächengebilde werden flexible Fasergebilde, wie z.B. Gewebe, Gelege, Gewirke, Gestricke, Vliese (verfestigt und unverfestigt) und Gitternetze verstanden.

Die Schicht, die das in einem Träger vorliegende Gettermaterial enthält, kann 0,5 bis 98 Gew.-% Gettermaterial enthalten. Bevorzugt enthält die Schicht 3 bis 85 Gew.-%, stärker bevorzugt 10 bis 60 Gew.-% Gettermaterial, jeweils bezogen auf das Gesamtgewicht der Schicht. Es hat sich gezeigt, dass in diesem Anteilsbereich zum einen gute Getterkapazitäten realisiert werden können und zum anderen die mechanischen Eigenschaften der Schicht ausreichend erhalten bleiben.

Ebenfalls bevorzugt liegt das Gettermaterial in einem Träger in Form von Partikeln in einer Partikelgrößenverteilung vor, bei der zumindest 10 Vol.-% die mittlere Schichtdicke der gettermaterialhaltigen Trägerschicht überschreiten. Dies führt zu einer rauen Oberfläche und kann die Verankerung der verschiedenen Schichten im Schichtverbund des erfindungsgemäßen Klebebandes verbessern. Besonders bevorzugt liegt das gesamte im erfindungsgemäßen Klebeband enthaltene Gettermaterial in einer Partikelgrößenverteilung vor, bei der zumindest 10 Vol.-% die mittlere Schichtdicke der gettermaterialhaltigen Schicht(en) überschreiten.

Der Gesamtgehalt des erfindungsgemäßen Klebebands an Gettermaterial kann von 0,5 bis 95 Gew.-%, bezogen auf das Gesamtgewicht des Klebebands, betragen. Der Gehalt hängt wesentlich von der gewünschten Aufnahmekapazität für den/die jeweiligen Permeaten ab.

Wenn zum Beispiel nur eine geringe Aufnahmekapazität erforderlich ist, reicht gegebenenfalls die Verwendung eines Gettermaterials mit geringer Aufnahmekapazität in einem geringen Gehalt aus. In einer bevorzugten Ausführungsform enthält das Klebeband daher 0,5 bis 30 Gew.-% Gettermaterial, bezogen auf das Gesamtgewicht des Klebebands. Die Dicke und die Fläche der getterhaltigen Schicht(en) können in diesem Fall vorteilhaft an den jeweiligen Untergrenzen liegen.

Bei einer sehr hohen erforderlichen Aufnahmekapazität des Klebebands muss jedoch eine Gettermaterial enthaltende Schicht mit relativ hohem Gehalt an Gettermaterial verwendet werden, wobei auch das Gettermaterial eine hohe Aufnahmekapazität besitzen sollte. Aber auch ein Gettermaterial mit geringer Aufnahmekapazität kann verwendet werden, wenn dies Kosten- oder Verträglichkeitsaspekte anraten. Im Rahmen einer weiteren bevorzugten Ausführungsform des erfindungsgemäßen Klebebands enthält dieses daher 50 bis 95 Gew.-% Gettermaterial, bezogen auf das Gesamtgewicht des Klebebands.

Bevorzugt weist das Gettermaterial in seiner Applikationsform - also als partikuläres Material - eine minimale Permeat-Aufnahmekapazität, insbesondere für Wasser und/oder Sauerstoff, besonders bevorzugt für Wasser, von 1 %, stärker bevorzugt von 2 %, besonders bevorzugt von 5 %, insbesondere von 10 % seines Eigengewichts auf. Insbesondere wird ein Gettermaterial mit hoher Aufnahmekapazität (maximal aufnehmbares Permeatgewicht > 20 % des Gettergewichts) bevorzugt, da hiermit der Gehalt an Getter gering gehalten werden kann. Die Aufnahmekapazität wird dabei nach Lagerung des im Wesentlichen permeatfreien Gettermaterials in seiner Applikationsform über 100 h bei 23 °C und 50 % eine sehr hohe Flexibilität des Klebebandes bei dann allerdings geringer Getterkapazität wird eine Schichtdicke von 50 nm bis 200 nm bevorzugt.

Grundsätzlich bevorzugt beträgt die Dicke der Getter-haltigen Schicht B allgemein mindestens 50 nm, bevorzugt mindestens 100 nm, besonders bevorzugt mindestens 200 nm und insbesondere mindestens 500 nm.

In einer weiteren Ausführungsform der Erfindung liegt das Gettermaterial in der Schicht B partikulär vor. Darunter wird verstanden, dass das Gettermaterial im Sinne von DIN 53206-1: 1972-08 in Form von Primärteilchen, Aggregaten und Agglomeraten vorliegt.

Die Partikelgröße der Getterpartikel wird wesentlich durch die Anforderungen an die Dicke der die Partikel enthaltenden Schicht oder des gesamten erfindungsgemäßen Klebebandes bestimmt beziehungsweise begrenzt. Als eine obere Grenze für die Partikelgröße können etwa 2000 µm angesehen werden. Bevorzugt beträgt die maximale Partikelgröße des Gettermaterials 100 µm. Unter der "Partikelgröße" wird dabei die maximale Ausdehnung eines Partikels verstanden. Die Bestimmung der Partikelgröße erfolgt bevorzugt mittels Laserbeugung nach ISO 13320 (wobei im Dispersionsschritt Agglomerate dispergiert werden, nicht jedoch Aggregate), aber auch andere dem Fachmann bekannte Verfahren sind grundsätzlich geeignet.

In einer besonders bevorzugten Ausführungsform liegt das Gettermaterial partikulär und nanoskalig vor. Dies bedeutet, dass die maximale Partikelgröße weniger als 500 nm, bevorzugt weniger als 200 nm, insbesondere weniger als 100 nm beträgt.

Bevorzugt liegt das Gettermaterial in der Schicht B partikulär vor und ist teilweise von einem Matrixmaterial umschlossen. Unter einem "Matrixmaterial" wird ein Material verstanden, das vorliegendes Gettermaterial, insbesondere partikuläres Gettermaterial, teilweise oder vollständig umhüllt und von dem Material der Klebemassenschichten A und C verschieden ist. Die Ausführungsform mit einem das Gettermaterial umgebenden Matrixmaterial unterscheidet sich somit von einem Aufbau des erfindungsgemäßen Klebebandes, in welchem das Material der Klebemassenschichten A und/oder C das Gettermaterial aufgrund der Fließfähigkeit der Klebemassen zumindest teilweise umhüllt, das umhüllende Material allerdings nicht verschieden von dem Material der Klebemassenschichten A und C ist.

In einer vorteilhaften Ausführung ist das Matrixmaterial eine Polymermasse, bevorzugt eine Haftklebemasse, besonders bevorzugt eine aus der Schmelze verarbeitete, thermisch vernetzte Polyacrylathaftklebemasse oder eine photopolymerisierte Polyacrylathaftklebemasse. Dadurch können die Eigenschaften der verschiedenen Haftklebemasseschichten auf deren Aufgabe im Verbund hin optimiert werden. Beispielsweise kann die Haftklebemasse für das Matrixmaterial eine besonders einfache Dispersion des Gettermaterials ermöglichen oder besonders gut für Permeate durchlässig sein, damit diese schnell zum Gettermaterial gelangen.

Besonders vorteilhaft ist eine Ausführung der Haftklebemasse als viskoelastischer Träger, z.B. auf der Basis von aus der Schmelze verarbeiteten, thermisch vernetzbaren Polyacrylaten, wie sie in WO 2008/122489 A1, DE 102008052625 A1 oder DE 102008059050 A1 beschrieben sind, oder auf der Basis photopolymerisierbarer Acrylate, wie sie in US 4,150,170, US 4,181,752, US 4,330,590, US 4,379,201, US 4,391,687 oder EP 0 573 570 B1 beschrieben sind. Mit einer derartigen Ausführung des Klebebandes kann eine sehr hohe Verklebungsleistung erreicht werden.

Liegt das Gettermaterial in einer Matrix vor, so ist die das Gettermaterial enthaltende Schicht B bevorzugt 1 µm bis 3000 µm dick. Wird nur eine geringe Aufnahmekapazität benötigt oder soll das Klebeband möglichst flexibel sein, wird eine Dicke von 1 bis 100 µm bevorzugt. Wird eine hohe Aufnahmekapazität benötigt, wird eine Dicke von 500 bis 3000 µm bevorzugt.

Beispielsweise kann das anorganische Gettermaterial in einem Träger, bevorzugt in den Poren eines porösen Trägermaterials, vorliegen. Dabei füllt das Gettermaterial die Poren nicht vollständig aus, sondern ist darin lediglich - zum Beispiel geometrisch - fixiert, so dass das gettergefüllte Trägermaterial sehr gasdurchlässig ist. Dies hat den Vorteil, dass einwandernde Permeate sehr schnell an das Gettermaterial gelangen können und gleichzeitig durch das Trägermaterial eine hohe innere Festigkeit des Schichtverbunds erreicht werden kann. Poröse Trägermaterialien sind auch besonders zur Aufnahme flüssiger Gettermaterialien geeignet.

Als poröses Trägermaterial können beispielsweise textile Flächengebilde, geschlossen- und offenzellige Schäume oder Papiere eingesetzt werden. Besonders bevorzugt ist der poröse Träger mit darin vorliegendem Gettermaterial aber eine extrudierte und verstreckte Folie, z.B. auf Polyolefinbasis, wie sie in EP 0 232 060 A2 beschrieben wird. Demnach wird ein solcher gasdurchlässiger, poröser Film im Wesentlichen in folgenden Schritten hergestellt:
a) Mischen eines Polymerharzes und eines anorganischen Gettermaterials,
b) Formen eines Films aus der Mischung und
c) Strecken des erhaltenen Films zur Ausbildung der Porosität.

Durch die Auswahl eines Polyolefins als Polymerharz ergibt sich aufgrund der Polaritätsunterschiede zum anorganischen Gettermaterial nur eine schwache Verankerung zwischen den beiden Materialien. Während der Verstreckung wird diese Verbindung zumindest teilweise gelöst, so dass um die dispers verteilten Getterteilchen Poren entstehen, die sich durch eine besonders gute Zugänglichkeit des Gettermaterials für Permeate auszeichnen. Das Gettermaterial liegt also nach dem Verstrecken nicht mehr vollständig von Matrixmaterial umhüllt vor. Durch die Wahl einer Folie als Trägermaterial ergibt sich zudem vorteilhaft eine gute Stanz- und Applizierbarkeit des Aufbaus. Bevorzugt weist die verstreckte, mit anorganischem Gettermaterial gefüllte Folie eine Dicke von weniger als 10 µm, besonders bevorzugt von weniger als 5 µm auf. Dies erlaubt vorteilhaft die Ausbildung einer höheren Flexibilität des erfindungsgemäßen Klebebandes.

Unter textilem Flächengebilde werden flexible Fasergebilde, wie z.B. Gewebe, Gelege, Gewirke, Gestricke, Vliese (verfestigt und unverfestigt) und Gitternetze verstanden.

Die Schicht, die das in einem Träger vorliegende Gettermaterial enthält, kann 0,5 bis 98 Gew.-% Gettermaterial enthalten. Bevorzugt enthält die Schicht 3 bis 85 Gew.-%, stärker bevorzugt 10 bis 60 Gew.-% Gettermaterial, jeweils bezogen auf das Gesamtgewicht der Schicht. Es hat sich gezeigt, dass in diesem Anteilsbereich zum einen gute Getterkapazitäten realisiert werden können und zum anderen die mechanischen Eigenschaften der Schicht ausreichend erhalten bleiben.

Ebenfalls bevorzugt liegt das Gettermaterial in einem Träger in Form von Partikeln in einer Partikelgrößenverteilung vor, bei der zumindest 10 Vol.-% die mittlere Schichtdicke der gettermaterialhaltigen Trägerschicht überschreiten. Dies führt zu einer rauen Oberfläche und kann die Verankerung der verschiedenen Schichten im Schichtverbund des erfindungsgemäßen Klebebandes verbessern. Besonders bevorzugt liegt das gesamte im erfindungsgemäßen Klebeband enthaltene Gettermaterial in einer Partikelgrößenverteilung vor, bei der zumindest 10 Vol.-% die mittlere Schichtdicke der gettermaterialhaltigen Schicht(en) überschreiten.

Der Gesamtgehalt des erfindungsgemäßen Klebebands an Gettermaterial kann von 0,5 bis 95 Gew.-%, bezogen auf das Gesamtgewicht des Klebebands, betragen. Der Gehalt hängt wesentlich von der gewünschten Aufnahmekapazität für den/die jeweiligen Permeaten ab.

Wenn zum Beispiel nur eine geringe Aufnahmekapazität erforderlich ist, reicht gegebenenfalls die Verwendung eines Gettermaterials mit geringer Aufnahmekapazität in einem geringen Gehalt aus. In einer bevorzugten Ausführungsform enthält das Klebeband daher 0,5 bis 30 Gew.-% Gettermaterial, bezogen auf das Gesamtgewicht des Klebebands. Die Dicke und die Fläche der getterhaltigen Schicht(en) können in diesem Fall vorteilhaft an den jeweiligen Untergrenzen liegen.

Bei einer sehr hohen erforderlichen Aufnahmekapazität des Klebebands muss jedoch eine Gettermaterial enthaltende Schicht mit relativ hohem Gehalt an Gettermaterial verwendet werden, wobei auch das Gettermaterial eine hohe Aufnahmekapazität besitzen sollte. Aber auch ein Gettermaterial mit geringer Aufnahmekapazität kann verwendet werden, wenn dies Kosten- oder Verträglichkeitsaspekte anraten. Im Rahmen einer weiteren bevorzugten Ausführungsform des erfindungsgemäßen Klebebands enthält dieses daher 50 bis 95 Gew.-% Gettermaterial, bezogen auf das Gesamtgewicht des Klebebands.

Bevorzugt weist das Gettermaterial in seiner Applikationsform - also beispielsweise als geschlossene oder durchbrochene Schicht, als partikuläres Material etc. - eine minimale Permeat-Aufnahmekapazität, insbesondere für Wasser und/oder Sauerstoff, besonders bevorzugt für Wasser, von 1 %, stärker bevorzugt von 2 %, besonders bevorzugt von 5 %, insbesondere von 10 % seines Eigengewichts auf. Insbesondere wird ein Gettermaterial mit hoher Aufnahmekapazität (maximal aufnehmbares Permeatgewicht > 20 % des Gettergewichts) bevorzugt, da hiermit der Gehalt an Getter gering gehalten werden kann. Die Aufnahmekapazität wird dabei nach Lagerung des im Wesentlichen permeatfreien Gettermaterials in seiner Applikationsform über 100 h bei 23 °C und 50 % relativer Luftfeuchte für das Permeat Wasserdampf oder bei 23 °C in gesättigter Atmosphäre bei anderen gasförmigen Permeaten ermittelt. Der Permeatgehalt des Getters nach Lagerung kann gravimetrisch bestimmt werden. Unter dem Aspekt der Aufnahmekapazität ist das Gettermaterial bevorzugt ausgewählt aus der Gruppe umfassend Kupfersulfat, Calciumoxid, Calciumchlorid und Zeolithe sowie Gemische dieser Materialien.

Das Einbringen des Gettermaterials oder der Gettermaterialien in die betreffende(n) Schicht(en) kann durch sämtliche dem Fachmann bekannte Verfahren erfolgen. Dabei kann das Gettermaterial in Lösung, in Dispersion, als Schmelze oder als Fluid vorliegen.

Die Gettermaterial enthaltende Schicht B kann neben dem Gettermaterial und gegebenenfalls dem Trägermaterial weitere Materialien beziehungsweise Substanzen enthalten, z.B. lichtabsorbierende oder lichtstreuende Materialien, UV-Absorber oder -reflektoren, Farbindikatoren, die eine Sättigung des Gettermaterials anzeigen, Alterungsschutzmittel und/oder Tackifier, insbesondere Klebharze.

Die Gettermaterial enthaltende Schicht kann direkt mittels dem Fachmann bekannter Beschichtungsverfahren, z.B. eines Streichbalkens, aus der Lösung, Emulsion oder Dispersion aufgebracht werden. Das verwendete Löse-, Emulsions- beziehungsweise Dispergiermittel kann in diesem Fall anschließend in einem handelsüblichen Trockenkanal verdampft werden. Ebenso ist eine lösungsmittelfreie Beschichtung, zum Beispiel mittels Streu, Beflockungs- oder Bepuderungsverfahren geeignet.

Die Gettermaterial enthaltende Schicht kann erfindungsgemäß auch gedruckt werden. Hierzu eignen sich nach dem Stand der Technik Tief- und Siebdruckverfahren. Bevorzugt werden hier rotative Druckverfahren angewendet. Ferner können Gettermaterial-haltige Schichten auch durch Aufsprühen aufgebracht werden, gegebenenfalls auch mit elektrostatischer Unterstützung.

Das erfindungsgemäße Klebeband kann zwischen den äußeren Klebemasseschichten A und C neben der Schicht B eine oder mehrere weitere Schicht(en) enthalten, die mindestens ein anorganisches Gettermaterial enthalten. Diese weiteren Schichten können gleich oder verschieden sein und in ihrem Aufbau den vorstehend beschriebenen Gettermaterial-haltigen Schichten entsprechen.

Darüber hinaus können die weiteren Gettermaterial-haltigen Schichten mit der Schicht B beziehungsweise untereinander direkt in Kontakt stehen oder durch mindestens eine weitere, kein Gettermaterial enthaltende Schicht voneinander getrennt vorliegen. Diese weitere, kein Gettermaterial enthaltende Schicht kann beispielsweise eine Klebemasseschicht oder eine Trägerschicht sein.

Bevorzugt enthält das erfindungsgemäße Klebeband neben den Schichten A, B und C eine zusätzliche Trägerschicht, die kein Gettermaterial enthält und zwischen den Schichten A und C angeordnet ist. Als Material einer zusätzlichen Trägerschicht des erfindungsgemäßen Klebebands kommen beispielsweise textile Materialien, Papiere, kunststoffbeschichtete Papiere und Folien in Frage. Bevorzugt ist die zusätzliche Trägerschicht eine Folie und als solche besonders bevorzugt eine dimensionsstabile Kunststofffolie. Eine derartige zusätzliche Trägerschicht verbessert vorteilhaft die Applizierbarkeit und die Stanzbarkeit des Klebebandes. Eine dimensionsstabile Kunststofffolie als Trägerschicht enthält als Basismaterial bevorzugt Polyester, insbesondere Polyethylenterephthalat, beispielsweise biaxial verstrecktes Polyethylenterephthalat; Polyolefine, insbesondere Polybuten, Cycloolefin-Copolymere, Polymethylpenten, Polypropylen und/oder Polyethylen, beispielsweise monoaxial verstrecktes Polypropylen, biaxial verstrecktes Polypropylen und/oder biaxial verstrecktes Polyethylen.
Polyesterfolien weisen den Vorteil auf, dass sie für Temperaturstabilität sorgen und eine erhöhte mechanische Stabilität einbringen. Ganz besonders bevorzugt enthält die Trägerschicht daher als Basismaterial einen Polyester, beispielsweise biaxial verstrecktes Polyethylenterephthalat. Unter "Basismaterial" wird der wesentliche Bestandteil der betreffenden Schicht beziehungsweise Folie verstanden, wobei diese Schicht Hilfsstoffe in untergeordneten Mengen enthalten kann. Das Basismaterial ist üblicherweise zu einem Anteil von mindestens 80 Gew.-% in der betreffenden Schicht enthalten.

Weiterhin enthält das erfindungsgemäße Klebeband bevorzugt eine Barriereschicht gegen ein oder mehrere spezifische(s) Permeat(e), insbesondere gegen Wasserdampf und Sauerstoff. Eine derartige Barrierefunktion kann aus organischen oder anorganischen Materialien bestehen.

Besonders bevorzugt enthält das erfindungsgemäße Klebeband mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, beispielsweise Aluminium, Silber, Gold, Nickel und/oder Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Um eine genügende Flexibilität bei gleichzeitiger Vermeidung von Rissbildung in der anorganischen Barriereschicht zu gewährleisten, sind solche Schichten in der Regel dünner als etwa 50 nm. Damit und aufgrund der hohen Kompaktheit, die ja eine Permeation verhindern soll, eigenen sich solche Schichten nicht selbst als Getterschichten, da sie keine hinreichende Aufnahmekapazität für Permeate bieten.

Besonders bevorzugt enthält das erfindungsgemäße Klebeband neben den Schichten A, B und C mindestens eine Trägerschicht und mindestens eine Barriereschicht gegen ein oder mehrere Permeat(e), wobei die Barriereschicht und die Trägerschicht als unmittelbar aufeinanderfolgende Schichten vorliegen, die zwischen den Schichten A und C angeordnet sind. Als besonders geeignetes Verfahren zum Aufbringen einer anorganischen Barriereschicht sind High-Power-Impulse-Magnetron-Sputtering und Atomic-Layer-Deposition zu nennen, durch die sich besonders permeationsdichte Schichten bei geringer Temperaturbelastung der Trägerschicht verwirklichen lassen. Bevorzugt wird eine Permeationsbarriere der Barriereschicht beziehungsweise des Verbundes aus Trägerschicht und Barriereschicht gegen Wasserdampf (WVTR) von < 1 g/(m²*d) und/oder gegen Sauerstoff (OTR) von < 1 cm³/(m²*d*bar), wobei der Wert auf die jeweils im Klebeband verwendete Dicke der Trägerschicht bezogen ist, also nicht auf eine spezifische Dicke normiert ist. Die WVTR wird dabei bei 38°C und 90% relativer Luftfeuchtigkeit nach ASTM F-1249 und die OTR bei 23°C und 50% relativer Luftfeuchtigkeit nach DIN 53380-Teil 3 gemessen.

Das erfindungsgemäße Klebeband kann an seinen Außenseiten jeweils mit einem Releaseliner abgedeckt sein. Ein Releaseliner wird jedoch nicht als Bestandteil des Klebebands angesehen, sondern stellt lediglich ein Hilfsmittel zu dessen Herstellung, Lagerung und/oder Weiterverarbeitung dar.

Bevorzugt ist das erfindungsgemäße Klebeband transparent, das heißt die Transmission gemessen nach ASTM D1003-00 (Procedure A) ist größer als 50 %, bevorzugt größer als 75 %. Mit Transparenz kann das Klebeband in der Anwendung leichter positioniert werden und in Anwendungen, bei denen Transparenz erforderlich ist, zum Beispiel Licht emittierende elektronische Aufbauten oder Solarzellen, für eine zumindest teilflächige Überklebung des elektronischen Aufbaus verwendet werden.

Besonders bevorzugt ist das erfindungsgemäße Klebeband UV-Licht-undurchlässig, das heißt die Transmission in einem Wellenlängenbereich von 200 bis 400 nm, gemessen nach ASTM D1003-00 (Procedure B), ist geringer als 25 %, bevorzugt geringer als 10 %. Mit einem UV-undurchlässigen Klebeband kann ein elektronischer Aufbau vor Veränderungen (zum Beispiel chemische Reaktionen, Alterung, Vernetzung) durch den Einfluss von UV-Licht geschützt werden.

Das erfindungsgemäße Klebeband enthält in einer speziellen Ausführung nur die Schichten A, B und C; als Schicht B ist bei diesem Aufbau bevorzugt eine Schicht anorganischen Gettermaterials enthalten, also kein Trägermaterial sowie kein das Gettermaterial einbettendes Matrixmaterial (Transferklebeband), da hierdurch der Aufbau einfach gehalten und die Zahl der zu berücksichtigenden möglichen Permeate durch die geringere Materialvielfalt klein gehalten werden kann. Bei einer derartigen Ausführungsform stehen die Schichten B und A bzw. C in unmittelbarem Kontakt durcheinander. Sofern das Klebeband zusätzlich Primerschichten zwischen A und B bzw. B und C enthält, sind diese bevorzugt nicht dicker als 1 µm. Dies bewirkt eine gute Erreichbarkeit der Gettermaterialien für die Permeate.

Die Dicke des erfindungsgemäßen Klebebands kann alle üblichen Dicken umfassen, also etwa von 3 µm bis zu 3000 µm. Bevorzugt wird eine Dicke zwischen 25 und 100 µm, da in diesem Bereich Klebkraft und Handlingeigenschaften besonders positiv ausfallen. Ein weiterer bevorzugter Bereich ist eine Dicke von 3 bis 25 µm, da in diesem Bereich die Menge von durch die Klebefuge permeierenden Stoffen allein durch die kleine Querschnittsfläche der Klebefuge in einer Verkapselungsanwendung gering gehalten werden kann.

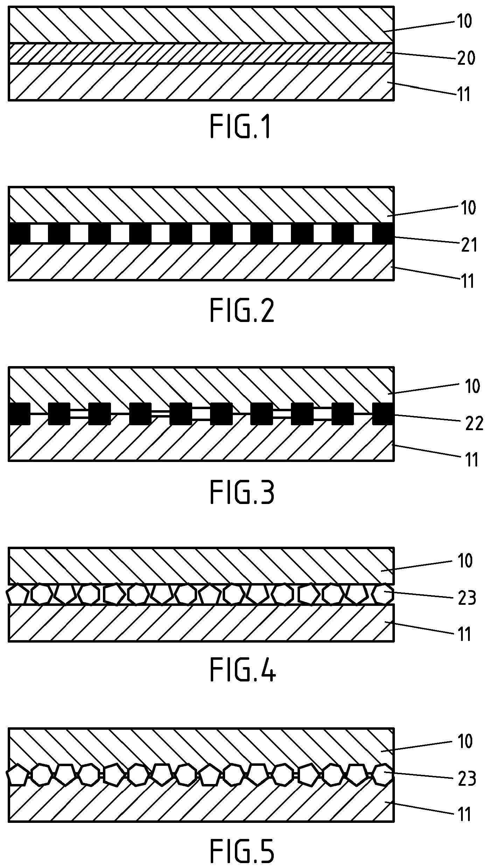

Beispielhafte Varianten des Aufbaus eines Klebebands sind in den Figuren 1 bis 12 dargestellt. Die Figuren sind rein schematisch und nicht maßstäblich dargestellt. Darin bedeuten:
- 10, 11:: Klebemasseschicht
- 20-25:: Gettermaterial enthaltende Schicht
- 30:: Trägerschicht
- 40, 41:: Releaseliner
- 50:: anorganische Barriereschicht

Figur 1 stellt ein nicht erfindungsgemäßes Klebeband dar, das aus zwei Klebemasseschichten 10, 11 sowie einer dazwischen liegenden durchgehenden Schicht 20 aus anorganischem Gettermaterial besteht.
Figur 2 stellt ein nicht erfindungsgemäßes Klebeband dar, das aus zwei Klebemasseschichten 10, 11 sowie einer dazwischen liegenden durchbrochenen Schicht 21 aus anorganischem Gettermaterial besteht.
Figur 3 stellt ein nicht erfindungsgemäßes Klebeband dar, das aus zwei Klebemasseschichten 10, 11 sowie einer dazwischen liegenden durchbrochenen Schicht 22 aus anorganischem Gettermaterial besteht, wobei die Klebemassen in die Schicht aus Gettermaterial eindringen und dieses zumindest teilweise umschließen.
Figur 4 stellt ein nicht erfindungsgemäßes Klebeband dar, das aus zwei Klebemasseschichten 10, 11 sowie einer dazwischen liegenden Schicht 21 aus partikulärem anorganischem Gettermaterial besteht.
Figur 5 stellt ein nicht erfindungsgemäßes Klebeband dar, das aus zwei Klebemasseschichten 10, 11 sowie einer dazwischen liegenden Schicht 23 aus partikulärem anorganischem Gettermaterial besteht, wobei die Klebemassen in die Schicht aus Gettermaterial eindringen und dieses zumindest teilweise umschließen.

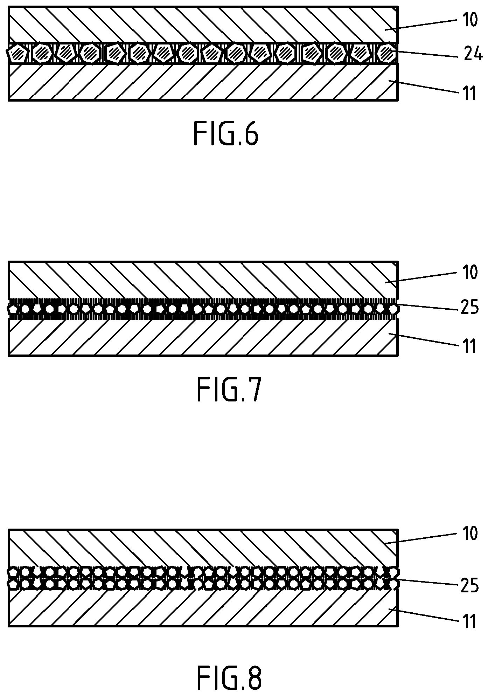

Figur 6 stellt ein erfindungsgemäßes Klebeband dar, das aus zwei Klebemasseschichten 10, 11 sowie einer dazwischen liegenden Schicht 24 aus partikulärem anorganischem Gettermaterial besteht, wobei das Gettermaterial in einer verstreckten Polymermatrix eingebettet vorliegt. Das Matrixmaterial benetzt die Getterpartikel nicht vollständig (in der
Figur nicht explizit dargestellt), sondern allenfalls teilweise. Es entsteht somit eine Porosität, die Permeate leicht an die Oberfläche des Gettermaterials gelangen lässt.
Figur 7 stellt ein erfindungsgemäßes Klebeband dar, das aus zwei Klebemasseschichten 10, 11 sowie einer dazwischen liegenden Schicht 25 aus partikulärem anorganischem Gettermaterial besteht, wobei das Gettermaterial in einem textilen Flächengebilde lose eingebettet vorliegt.
Figur 8 stellt ebenfalls ein erfindungsgemäßes Klebeband dar, das aus zwei Klebemasseschichten 10, 11 sowie einer dazwischen liegenden Schicht 25 aus partikulärem anorganischem Gettermaterial besteht, wobei das Gettermaterial in einem textilen Flächengebilde lose eingebettet vorliegt.

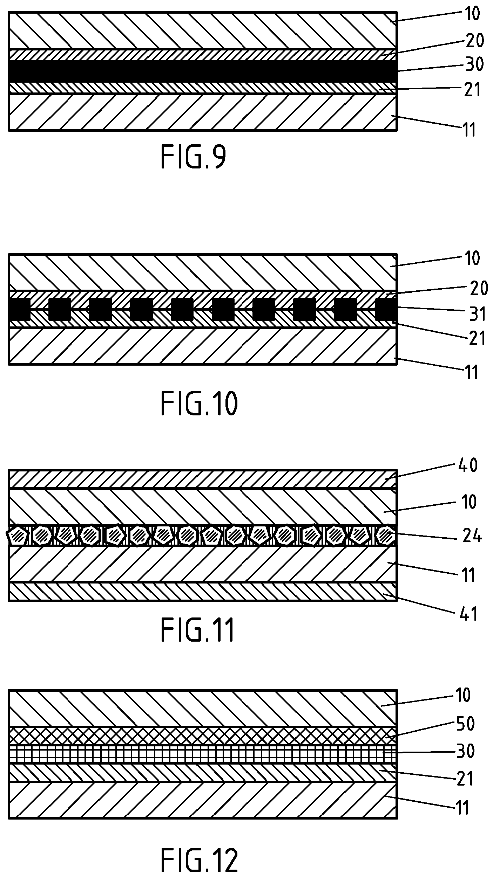

Figur 9 stellt ein nicht erfindungsgemäßes Klebeband dar, das aus zwei Klebemasseschichten 10, 11 sowie zwei dazwischen liegenden durchgehenden Schichten 20, 21 aus anorganischem Gettermaterial besteht, wobei die Schichten 20 und 21 auf jeweils einer Seite eines durchgehenden Trägermaterials 30 aufgebracht vorliegen.
Figur 10 stellt ein nicht erfindungsgemäßes Klebeband dar, das aus zwei Klebemasseschichten 10, 11 sowie zwei dazwischen liegenden durchgehenden Schichten 20, 21 aus anorganischem Gettermaterial besteht, wobei die Schichten 20 und 21 auf jeweils einer Seite eines durchbrochenen Trägermaterials 31 aufgebracht vorliegen.
Figur 11 stellt ein erfindungsgemäßes Klebeband dar, das aus zwei Klebemasseschichten 10, 11 sowie einer dazwischen liegenden Schicht 24 aus partikulärem anorganischem Gettermaterial besteht, wobei das Gettermaterial in einer verstreckten Polymermatrix eingebettet vorliegt und die Klebemassen mit Releaselinern 40, 41 abgedeckt sind.
Figur 12 stellt ein nicht erfindungsgemäßes Klebeband dar, das aus zwei Klebemasseschichten 10, 11 sowie einer dazwischen liegenden durchgehenden Schicht 20 aus anorganischem Gettermaterial sowie einer anorganischen Barriereschicht 50 besteht, wobei die Schicht 20 auf einer Seite und die anorganische Barriereschicht 50 auf der anderen Seite eines durchgehenden Trägermaterials 30 aufgebracht vorliegt.

Offenbart wird auch ein Verfahren zur Herstellung eines erfindungsgemäßen Klebebands, das folgende Schritte umfasst:
- Bereitstellen einer ersten Klebemassenschicht A;
- Aufbringen einer mindestens ein anorganisches Gettermaterial enthaltenden Schicht B auf die Schicht A, beispielsweise durch Beschichten oder Laminieren;
- Überdecken der freien Seite der Schicht B mit einer weiteren Klebemassenschicht C, beispielsweise durch Beschichten oder Laminieren.

Eine alternative Ausführungsform des Verfahrens zur Herstellung eines erfindungsgemäßen Klebebands umfasst die folgenden Schritte:
- Bereitstellen eines Hilfsträgers, beispielsweise eines abhäsiv ausgerüsteten Liners, einer abhäsiv ausgerüsteten Bahn oder Walze;
- Aufbringen einer mindestens ein anorganisches Gettermaterial enthaltenden Schicht B;
- Überdecken der Schicht B mit einer ersten Klebemassenschicht A, zum Beispiel mittels Beschichten oder Laminieren;
- Ablösen des Verbundes vom Hilfsträger und Überdecken der freigelegten Oberfläche mit einer zweiten Klebemasseschicht C, zum Beispiel durch Beschichten oder Laminieren.

Bevorzugt finden die Verfahren in einer Umgebung statt, in der das spezifische Permeat nur in geringer Konzentration oder im Wesentlichen gar nicht enthalten ist. Als Beispiel lässt sich für den Fall von Wasser(dampf) als Permeat eine relative Luftfeuchtigkeit von weniger als 30 %, vorzugsweise von weniger als 15 %, anführen.

Offenbart wird auch die Verwendung von Calcium und/oder Calciumoxid zur Indikation des Permeatgehalts einer Klebemasse und/oder eines Klebebandes. So verändert Calciumoxid mit zunehmender Wasserbindung seine Farbe von weiß zu transparent. Auch metallisches Calcium verliert mit zunehmender Aufnahme von Wasser seine metallischundurchsichtige Erscheinung und wird zunehmend transparent. So lange also noch Gettermaterial in der optischen Erscheinung des unverbrauchten Zustands erkennbar ist, kann dies als Indiz dafür gelten, dass noch kein oder allenfalls wenig Permeat in die zu schützende Klebemasse diffundiert ist.

Ein weiterer Gegenstand der Erfindung ist die Verwendung eines erfindungsgemäßen Klebebands als Verkapselungsmaterial, insbesondere zum Schutz von elektronischen Anordnungen, Lebensmitteln und/oder Medikamenten. Ein erfindungsgemäßes Klebeband eignet sich hervorragend zur Kapselung einer elektronischen Anordnung gegen Permeate, indem das Klebeband auf und/oder um die zu kapselnden Bereiche der elektronischen Anordnung appliziert wird. Neben den schon erwähnten optoelektronischen Anordnungen ist die Verwendung ähnlich vorteilhaft möglich in weiteren elektronischen Anordnungen wie elektrochemischen Zellen, z.B. Brennstoffzellen oder Elektrolysezellen, und/oder Batterien. Auch im Bereich der Verpackungen, insbesondere der Lebensmittel oder Medikamentenverpackungen, sind erfindungsgemäße Klebebänder gut geeignet.

Als Kapselung wird vorliegend nicht nur ein vollumfänglicher Einschluss des zu kapselnden Bereichs bezeichnet, sondern auch bereits eine bereichsweise Applikation eines erfindungsgemäßen Klebebands auf den zu kapselnden Bereichen insbesondere einer elektronischen Anordnung, beispielsweise ein einseitiges Überdecken oder ein Umrahmen einer elektronischen Struktur.

Im Prinzip können mit Klebebändern zwei Arten der Verkapselung durchgeführt werden. Entweder wird das Klebeband zuvor ausgestanzt oder zugeschnitten und nur um die zu kapselnden Bereiche herum verklebt, oder es wird vollflächig über die zu kapselnden Bereiche geklebt. Ein Vorteil der zweiten Variante ist die einfachere Handhabung und der häufig bessere Schutz.

### Beispiele

Es wurden verschiedene mit Gettermaterial gefüllte Klebebänder hergestellt. Diese wurden aus verschiedenen Schichten mittels eines Labor-Walzenlaminators im Klimaraum bei 23 °C und einer relativen Luftfeuchte von 50 % laminiert.

### Klebemasseschichten :

Zur Herstellung von Klebemasseschichten wurden verschiedene Klebemassen aus einer Lösung auf einen konventionellen Liner des Typs Silphan S75 M371 der Firma Siliconature mittels eines Laborstreichgeräts aufgebracht und getrocknet. Die Klebemassenschichtdicke nach dem Trocknen betrug jeweils 12 µm. Die Trocknung erfolgte jeweils bei 120 °C über 30 min in einem Labortrockenschrank. Die Angabe "Teile" in der nachfolgenden Auflistung bedeutet "Gewichtsteile".
K1: Haftklebemasse

| | | |
|---|---|---|
| 100 Teile | Tuftec P 1500 | SBBS mit 30 Gew.-% Blockpolystyrolgehalt der Firma Asahi. |
| | | Das SBBS enthält ca. 68 Gew.-% Zweiblockgehalt. |
| 100 Teile | Escorez 5600 | Hydriertes KW-Harz mit einem Erweichungspunkt von 100 °C der Firma Exxon |
| 25 Teile | Ondina 917 | Weißöl aus paraffinischen und naphthenischen Anteilen der Firma Shell |

Als Lösungsmittel wurde ein Gemisch aus Toluol und Aceton im Verhältnis 2:1 verwendet.
K2: Heißschmelzklebemasse

| | | |
|---|---|---|
| 100 Teile | Kraton FG 1924 | Maleinsäureanhydridmodifiziertes SEBS mit 13 Gew.-% Blockpolystyrolgehalt, 36 Gew.-% Zweiblock und 1 Gew.-% Maleinsäure der Firma Kraton |
| 25 Teile | Escorez 5600 | Hydriertes KW-Harz (Kohlenwasserstoffharz) mit einem Erweichungspunkt von 100 °C der Firma Exxon |
| 1 Teil | Aluminiumacetylacetonat | |

Als Lösungsmittel wurde ein Gemisch aus Toluol und Aceton im Verhältnis 2:1 verwendet.
K3: Strahlenaktivierbare Heißschmelzklebemasse

| | | |
|---|---|---|
| 25 Teile | Epiclon 835 LV | Bisphenol-A und Bisphenol-F - basiertes Epoxidharz der Firma DIC, Japan, Molekulargewicht M_{W} ca. 350 g/mol |
| 25 Teile | Epicote 1001 | Bisphenol-basiertes Epoxidharz der Firma Mitsubishi Chemical Company, Japan, Molekulargewicht M_{W} ca. 900 g/mol |
| 50 Teile | YP-70 | Bisphenol-A und Bisphenol-F - basiertes Phenoxyharz der Fa. Nippon Steel Chemical Group, Japan, Molekulargewicht M_{W} ca. 55.000 g/mol |
| 1,5 Teile | Irgacure 250 | lodonium-Salz-basierter UV-Photoinitiator der Fa. BASF (lodonium, (4-methylphenyl) [4-(2-methylpropyl) phenyl]-, hexafluorophosphate(1-)) |

Als Lösemittel wurde Methylethylketon verwendet.
K4: Hitzeaktivierbare Klebemasse

| | | |
|---|---|---|
| 90 Teile | Ultramid 1C | Copolyamid 6/66/136 der Fa. BASF mit einer Viskositätszahl in 96 %iger Schwefelsäure nach ISO 307 von 122 ml/g |
| 10 Teile | EPR 166 | Bisphenol-basiertes Epoxidharz der Firma Bakelite, Epoxidzahl von 184 |
| 20 Teile | PEG 2000 | Polyethylenglycol mit der mittleren Molmasse 2000 |
| 20 Teile | Foralyn 5040 | Klebharz der Firma Eastman |

Die Klebemasse wurde in einem Prozess, wie er in DE 102006047739 A1 offengelegt ist, mit Ethanol als Lösemittel hergestellt.

Die Klebemasseschichten wurden über 72 Stunden bei 23°C und 50 % relativer Luftfeuchte (Konditionierung A) gelagert. Der Wassergehalt der Klebemasseschichten wurde vor dem Zusammenbringen mit dem Gettermaterial jeweils ermittelt.

### Messung des Wassergehalts

Der Wassergehalt wurde ermittelt nach DIN 53715 (Karl-Fischer-Titration). Die Messung erfolgte an einem Karl-Fischer Coulometer 851 in Verbindung mit einem Ovensampler (Ofentemperatur 140 °C). Mit einer Einwaage von ca. 0,3 g wurde jeweils eine Dreifachbestimmung durchgeführt. Als Wassergehalt wird der arithmetische Mittelwert der Messungen angegeben.

### Messung der Wasserdampfpermeationsrate

Die WVTR wird bei 38°C und 90% relativer Luftfeuchtigkeit nach ASTM F-1249 gemessen und auf eine Dicke von 50 µm normiert.

| Klebemasseschicht | Wassergehalt [ppm] Konditionierung A | Wasserdampfpermeationsrate [g/m² d] |
|---|---|---|
| K1 | 853 | 37 |
| K2 | 551 | 22 |
| K3 | 3216 | 32 |
| K4 | 16400 | 220 |

Von der Klebemasseschicht 1 wurden zusätzlich auch Muster bei 120 °C nur 5 min lang getrocknet. Der verbliebene Restlösemittelgehalt wurde unmittelbar nach dem Trocknen ermittelt.

### Ermittlung des Restlösemittelgehalts:

Der Restlösemittelgehalt der Klebemassen wurde mittels Headspace-Gaschromatografie ermittelt. Es wurde eine etwa 12,5 cm² große Probenfläche aus dem Lappenmuster ausgeschnitten, auf eine Metalldrahtspirale geklebt und in ein ca. 22 ml großes Headspace-Probengläschen überführt.

Die Proben wurden mit einem Dani GC 86.10 Gaschromatographen mit Quma QHS-S40 Autosampler vermessen. Die Proben wurden für 1 Stunde bei 120°C im Gerät temperiert. Die Detektion erfolgte mittels Flammenionisationsdetektor (FID). Die Quantifizierung der Peaks im GC erfolgte gegen externe Standards.

| Klebemasseschicht | Restlösemittelgehalt [mg/m²] (bezogen auf 25 µm Schichtdicke) |
|---|---|
| K1 (5 min Trocknung) | 102 |

### Herstellung Gettermaterial enthaltender Matrices:

### Matrixschicht mit nicht vollständig eingebettetem Gettermaterial (teilweise von Matrixmaterial umschlossenes Gettermaterial)

Die Polypropylen-Polymere Inspire D 404.01 und 7C06 der Firma Dow wurden im Verhältnis 1:1 gemischt und extrudiert. Die Mischung wird im Folgenden als "PP-Matrix" bezeichnet. Die Folie wurde auf einer Zweischneckenextrusionsanlage der Firma Coperion (d= 25 mm, L/d = 37) mit angeflanschter Flachdüse in einer Schicht hergestellt, gefolgt von einer Chillrollstation. Das Gettermaterial wurde mittels eines Sidefeeders nach dem Aufschmelzen und Homogenisieren der Polymerkomponenten in einer Menge von 30 Gew.-% zugeführt.

Die Düsentemperatur betrug 235°C, die Chillroll-Temperatur 85 °C. Nach dem Abkühlen wurde die Folie in einen Labor-Simultanstreckrahmen eingespannt und im Ofen bei einer Temperatur von 150 °C simultan in der Folienebene in zwei rechtwinklig zueinanderstehenden Richtungen gereckt. Das Reckverhältnis betrug in beiden Richtungen etwa 1:7. Die Folie hatte eine finale Dicke von etwa 30 µm.

Die hergestellte Folie wurde auf Ihre Wasserdampfdurchlässigkeit bei 38°C und 90% relativer Luftfeuchtigkeit nach ASTM F-1249 geprüft. Es ergaben sich bei einer Messfläche von 10 cm² Werte oberhalb der oberen Grenze des Messgeräts von 1000 g/m², so dass geschlossen werden kann, dass sich wie beabsichtigt Poren um die Getterpartikel gebildet haben.

### Matrixschicht mit eingebettetem Gettermaterial (von Matrixmaterial umschlossenes Gettermaterial)

Als weiteres Beispiel wurde die wie oben extrudierte Folie in einer Vakuumpresse der Firma Lauffer bei einer Temperatur von 230 °C zu einer Folie mit einem Flächengewicht von 30 g/m² verpresst.

Die hergestellte Folie wurde auf Ihre Wasserdampfdurchlässigkeit bei 38°C und 90% relativer Luftfeuchtigkeit nach ASTM F-1249 vermessen. Nach Einstellung des Gleichgewichtszustands (zuvor Sättigung des Gettermaterials) ergab sich eine Wasserdampfdurchlässigkeit von 43 g/m²d. Erwartungsgemäß wurde also das Gettermaterial vollständig vom Matrixmaterial umschlossen.

Die gettergefüllten Trägerschichten wurden unmittelbar nach der Herstellung in vakuumierten Beuteln aus einem permeationsdichten Folienlaminat (Polyesterfolie-Aluminiumfolie-Siegelkleberfilm) eingeschweißt, in einer Glovebox unter Stickstoffatmosphäre gelagert und erst unmittelbar vor der Verwendung entnommen.

### Verwendete Gettermaterialien:

| Bezeichnung | Beschreibung | Handelsname | Lieferant |
|---|---|---|---|
| G1 | Calciumoxid | Calcium oxide nanopowder | Sigma-Aldrich |
| G2 | Lithiumchlorid | Lithium chloride anhydrous | Sigma-Aldrich |
| G3 | Calcium | hochreines Calciumgranulat | Osnabruegge |
| G4 | Barium | hochreines Bariumgranulat | Osnabruegge |
| G5 | Zeolith 13X | Molecular Sieves, 13X powder | Sigma-Aldrich |

### Herstellung von Klebebändern:

Die Herstellung der Klebebänder erfolgte in einem trockenen Raumklima bei 23 °C und ca. 20 % relativer Feuchte.

Klebebänder mit den pulverförmigen Gettermaterialien G1, G2 und G5 wurden durch Aufstreuen einer Menge von etwa 2 g/m² mittels eines Siebes auf eine Seite einer Klebemasseschicht hergestellt. Sodann wurde die zweite Klebemasseschicht mittels eines Laborlaminiergeräts bei der jeweils unten angegebenen Temperatur auf die bestreute Seite auflaminiert.

Als Vergleichsbeispiel wurde die gleiche Menge Gettermaterial in die gelöste Klebemasse, die zuvor mittels Zeolithkugeln der Fa. Sigma-Aldrich von Wasser befreit worden war, hineindispergiert und die Klebemasse wie oben beschrieben ausgestrichen und getrocknet. Hier wurde eine Klebemasseschicht mit einer Dicke von 25 µm hergestellt.

Für Klebebänder mit den metallischen Gettermaterialien wurde das Metall aufgedampft, wobei jeweils eine Schichtdicke des Gettermaterials von etwa 300 nm hergestellt wurde. Zum einen wurde eine Seite der Klebemasseschicht bedampft und die bedampfte Seite sodann mit der zweiten Klebemasseschicht laminiert.

Zum anderen wurde eine Trägerfolie mit dem Gettermaterial bedampft. Diese Trägerfolie wurde auf beiden Seiten mit jeweils einer Klebemasseschicht wie oben angegeben zusammenlaminiert.

Als Trägerfolie wurde eine ca. 12 µm dicke, mit einer etwa 40 nm dicken anorganischen Barriereschicht beschichtete Polyesterfolie (GX-P-F der Firma Toppan Printing, im Folgenden "Barriere-PET" genannt) verwendet, wobei die Gettermaterialschicht auf die der anorganischen Barriereschicht gegenüberliegenden Seite der Polyesterfolie aufgebracht wurde.

Für Klebebänder mit einer das Gettermaterial enthaltenden Matrixschicht wurde die Matrixschicht beidseitig mit der jeweils angegebenen Klebemasseschicht laminiert.

Tabelle 1 zeigt die hergestellten Gettermaterial-haltigen Klebebänder im Überblick:

**Tabelle 1: Gettermaterial-gefüllte Klebebänder**

| Beispiel | Klebemasse 1 | Trägermaterial | Gettermaterial | Matrixmaterial | Klebemasse 2 | Laminiertemperatur-[°C] |
|---|---|---|---|---|---|---|
| 1 (V) | K1 | - | G1 | - | K1 | 60 |
| 2 (V) | K1 | - | G2 | - | K1 | |
| 3 (V) | K1 | - | G3 | - | K1 | |
| 4 (V) | K1 | - | G4 | - | K1 | |
| 5 | K1 | - | G1 | PP | K1 | |
| 6 | K1 | - | G2 | PP | K1 | |
| 7 (V) | K1 | Barriere-PET | G3 | - | K1 | |
| 8 (V) | K2 | - | G1 | - | K2 | 120 |
| 9 (V) | K2 | - | G2 | - | K2 | |
| 10 (V) | K2 | - | G3 | - | K2 | |
| 11 (V) | K2 | - | G4 | - | K2 | |
| 12 | K2 | - | G1 | PP | K2 | |
| 13 | K2 | - | G2 | PP | K2 | |
| 14 (V) | K2 | Barriere-PET | G3 | - | K2 | |
| 15 (V) | K3 | - | G1 | - | K3 | 100 |
| 16 (V) | K3 | - | G2 | - | K3 | |
| 17 (V) | K3 | - | G3 | - | K3 | |
| 18 (V) | K3 | - | G4 | - | K3 | |
| 19 | K3 | - | G1 | PP | K3 | |
| 20 | K3 | - | G2 | PP | K3 | |
| 21 (V) | K3 | Barriere-PET | G3 | - | K3 | |
| 22 (V) | K4 | - | G1 | - | K4 | 100 |
| 23 (V) | K4 | - | G2 | - | K4 | |
| 24 (V) | K4 | - | G3 | - | K4 | |
| 25 (V) | K4 | - | G4 | - | K4 | |
| 26 | K4 | - | G1 | PP | K4 | |
| 27 | K4 | - | G2 | PP | K4 | |
| 28 (V) | K4 | Barriere-PET | G3 | - | K4 | |
| 29 (V) | K1 * | - | G5 | - | K1* | 60 |
| 30 (V) | K1 | - | G1 | PP | K1 | 60 |
| 31 (V) | K1 | - | G2 | PP | K1 | 60 |
| V1 (V) | - | - | G1 | K1 | - | - |
| V2 (V) | - | - | G2 | K1 | - | - |
| V3 (V) | - | - | G5 | K1* | - | - |

| | | | | | | |
|---|---|---|---|---|---|---|
| * kurze Trocknung, mit Restlösemittel | | | | | | |

### V - Vergleichsbeispiel

Von den Beispielen 1, 2, 5, 6 und 29-31 sowie V1 - 3 wurden die Klebkräfte auf Stahl analog ISO 29862 (Methode 3) bei 23 °C und 50 % relativer Luftfeuchte bei einer Abzugsgeschwindigkeit von 300 mm/min und einem Abzugswinkel von 180° bestimmt. Als Verstärkungsfolie wurde eine geätzte PET-Folie mit einer Dicke von 50 µm verwendet, wie sie von der Fa. Coveme (Italien) erhältlich ist.

Die Verklebung des Messstreifens wurde dabei mittels eines Laborlaminators bei einer Temperatur von 60 °C vorgenommen. Tabelle 2 zeigt die Ergebnisse.

Zur weiteren Untersuchung wurden etwa 100 x 100 mm² große Klebebandabschnitte mit einem permeationsdichten Liner des Typs Alu I 38 UV1 der Firma Mondi, enthaltend einen Träger aus Aluminiumfolie, auf beiden Seiten abgedeckt. Die Lamination erfolgte bei einer Temperatur von 100 °C, um ein dichtes Anliegen des Liners zu ermöglichen. Der Liner verhindert so, dass Wasser während der Lagerung aus dem Klebeband in die Glovebox permeiert.

Die Muster wurden in der Glovebox bei den genannten Bedingungen über einen Zeitraum von 14 Tagen gelagert.

Abschließend wurde bei den Mustern der Wassergehalt bzw. der Toluolgehalt in der Klebemasse bestimmt. Proben wurden dabei aus der Mitte der Musterfläche entnommen, um Randeffekte zu vermeiden. Enthaltene Getter-, Träger oder Matrixmaterialien wurden nicht entfernt. Es wird davon ausgegangen, dass eine Regeneration des Getters und somit eine Freisetzung von Permeaten erst bei deutlich höheren Temperaturen, als sie zur Messung verwendet wurden, erfolgt. Die Ergebnisse sind in Tabelle 2 zusammengefasst:

**Tabelle 2: Überprüfung der Trocknung der Klebemasseschichten und deren Klebeigenschaften**

| Beispiel | Wassergehalt [ppm] | Klebkraft [N/cm] |
|---|---|---|
| 1 (V) | 480 | 6,1 |
| 2 (V) | 215 | 6,0 |
| 3 (V) | 459 | |
| 4 (V) | 632 | |
| 5 | 104 | 6,5 |
| 6 | 87 | 6,5 |
| 7 (V) | 734 | |
| 8 (V) | 320 | |
| 9 (V) | 80 | |
| 10 (V) | 306 | |
| 11 (V) | 421 | |
| 12 | 108 | |
| 13 | 84 | |
| 14 (V) | 489 | |
| 15 (V) | 2200 | |
| 16 (V) | 550 | |
| 17 (V) | 2103 | |
| 18 (V) | 2894 | |
| 19 | 244 | |
| 20 | 195 | |
| 21 (V) | 3364 | |
| 22 (V) | 28667 | |
| 23 (V) | 3757 | |
| 24 (V) | 27703 | |
| 25 (V) | 33663 | |
| 26 | 1670 | |
| 27 | 835 | |
| 28 (V) | 34096 | |
| 30 (V) | 207 (28d:122) | 6,5 |
| 31 (V) | 186 (28d: 106) | 6,5 |
| V1 (V) | 384 | 5,5 |
| V2 (V) | 96 | 4,6 |
| Beispiel | Restlösemittelgehalt [mg/m²] | |
| 29 (V) | 76 | 5,9 |
| V3 (V) | 69 | 6,0 |

Die Ergebnisse zeigen auf, dass bei den erfindungsgemäßen Klebebändern eine Trocknung der Klebemasse erreicht wird. Im Vergleich zu Klebebändern nach dem Stand der Technik (V1 - V3) erreichen die erfindungsgemäßen Klebebänder (Beispiele 5, 6) ähnliche Trocknungseffizienz, ohne jedoch deren Nachteile hinsichtlich der Verklebungseigenschaften aufzuweisen. So weisen die nach dem Stand der Technik hergestellten Vergleichsmuster V1 und V2 aufgrund der in der Klebemasse dispergierten Gettermaterialien geringere Klebkräfte auf.

Werden die Beispiele 5 und 6 mit den Beispielen 30 und 31 verglichen, so zeigt sich der Vorteil eines nur teilweise von Matrixmaterial umschlossenen partikulären Gettermaterials (Beispiele 5 und 6) gegenüber einem im Wesentlichen vollständig umschlossenen partikulären Gettermaterial (Beispiele 30 und 31): Nach 14 Tagen Lagerzeit zeigen Beispiele 5 und 6 einen deutlich geringeren Wassergehalt als Beispiele 31 und 32. Letztere wurden daraufhin weitere 14 Tage gelagert und zeigten daraufhin einen ähnlich niedrigen Wassergehalt wie die Beispiele 5 und 6. Die Trocknung bei erfindungsgemäßen Aufbauten mit nur teilweise von Matrixmaterial umschlossenem partikulärem Gettermaterial erfolgte also schneller.

## Patentansprüche

1. Klebeband, zumindest enthaltend folgende Schichten in der angegebenen Abfolge:
- eine erste äußere Klebemassenschicht A,
- eine Schicht B, mindestens enthaltend ein anorganisches Gettermaterial, und
- eine zweite äußere Klebemassenschicht C,
**dadurch gekennzeichnet, dass**
die Klebemassenschichten A und C jeweils unabhängig voneinander aus einer Haftklebemasse oder einer aktivierbaren Klebemasse bestehen;
das anorganische Gettermaterial ausgewählt ist aus der Gruppe bestehend aus Barium, Calcium, Calciumsulfat, Calciumchlorid, Calciumoxid, Natriumsulfat, Kaliumcarbonat, Kupfersulfat, Magnesiumperchlorat, Magnesiumsulfat, Lithiumchlorid, Kieselsäuren, Zeolithen sowie Mischungen aus zwei oder mehreren der vorstehenden Substanzen; und das anorganische Gettermaterial in der Schicht B partikulär vorliegt und teilweise von einem Matrixmaterial umschlossen ist.

2. Klebeband gemäß Anspruch 1, **dadurch gekennzeichnet, dass** das Matrixmaterial eine Polymermasse ist.

3. Klebeband gemäß mindestens einem der vorstehenden Ansprüche, **dadurch gekennzeichnet, dass** das anorganische Gettermaterial ausgewählt ist aus der Gruppe bestehend aus Calciumsulfat, Calciumchlorid, Calciumoxid, pyrogenen Kieselsäuren, Zeolithen sowie Mischungen aus zwei oder mehreren der vorstehenden Substanzen.

4. Klebeband gemäß mindestens einem der vorstehenden Ansprüche, **dadurch gekennzeichnet, dass** die Klebemassenschicht A und die Klebemassenschicht C jeweils eine Wasserdampfpermeationsrate (bezogen auf eine Dicke der Klebemasse von 50 µm und gemessen bei 38°C und 90% relativer Luftfeuchte nach ASTM F-1249) von weniger als 50 g/(m²*d) aufweisen.

5. Klebeband gemäß mindestens einem der vorstehenden Ansprüche, **dadurch gekennzeichnet, dass** das Klebeband neben den Schichten A, B und C eine zusätzliche Trägerschicht aufweist, die kein Gettermaterial enthält und zwischen den Schichten A und C angeordnet ist.

6. Klebeband gemäß mindestens einem der vorstehenden Ansprüche, **dadurch gekennzeichnet, dass** das Klebeband neben den Schichten A, B und C mindestens eine Trägerschicht und mindestens eine Barriereschicht gegen ein oder mehrere Permeat(e) aufweist, wobei die Barriereschicht und die Trägerschicht als unmittelbar aufeinander folgende Schichten vorliegen, die zwischen den Schichten A und C angeordnet sind.

7. Verwendung eines Klebebands gemäß einem der vorstehenden Ansprüche als Verkapselungsmaterial.

## Claims

1. Adhesive tape at least comprising the following layers in the order stated:
- a first outer layer, A, of adhesive,
- a layer B, at least comprising an inorganic getter material, and
- a second outer layer, C, of adhesive,
**characterized in that**
the layers A and C of adhesive consist in each case independently of one another of a pressure sensitive adhesive or an activatable adhesive;
the inorganic getter material is selected from the group consisting of barium, calcium, calcium sulfate, calcium chloride, calcium oxide, sodium sulfate, potassium carbonate, copper sulfate, magnesium perchlorate, magnesium sulfate, lithium chloride, silicas, zeolites, and also mixtures of two or more of the above substances; and
the inorganic getter material is present in particulate form in the layer B and is partially surrounded by a matrix material.

2. Adhesive tape according to Claim 1, **characterized in that** the matrix material is a polymer composition.

3. Adhesive tape according to at least one of the preceding claims, **characterized in that** the inorganic getter material is selected from the group consisting of calcium sulfate, calcium chloride, calcium oxide, fumed silicas, zeolites, and also mixtures of two or more of the above substances.

4. Adhesive tape according to at least one of the preceding claims, **characterized in that** the layer A of adhesive and the layer C of adhesive each have a water vapour permeation rate (based on an adhesive thickness of 50 µm and measured at 38°C and 90% relative humidity in accordance with ASTM F-1249) of less than 50 g/(m²*d).

5. Adhesive tape according to at least one of the preceding claims, **characterized in that** the adhesive tape, besides layers A, B, and C, has an additional carrier layer which does not comprise any getter material and is disposed between the layers A and C.

6. Adhesive tape according to at least one of the preceding claims, **characterized in that** the adhesive tape, in addition to layers A, B, and C, has at least one carrier layer and at least one barrier layer against one or more permeates, the barrier layer and the carrier layer being present in the form of layers which follow one another immediately and are disposed between the layers A and C.

7. Use of an adhesive tape according to any of the preceding claims as encapsulation material.

## Revendications

1. Bande adhésive, contenant au moins les couches suivantes dans l'ordre indiqué :
- une première couche de masse adhésive extérieure A,
- une couche B, contenant au moins un matériau piégeur inorganique, et
- une deuxième couche de masse adhésive extérieure C,
**caractérisée en ce que**
les couches de masse adhésive A et C sont chacune constituées indépendamment l'une de l'autre par une masse adhésive sensible à la pression ou une masse adhésive activable ;
le matériau piégeur inorganique est choisi dans le groupe constitué par le baryum, le calcium, le sulfate de calcium, le chlorure de calcium, l'oxyde de calcium, le sulfate de sodium, le carbonate de potassium, le sulfate de cuivre, le perchlorate de magnésium, le sulfate de magnésium, le chlorure de lithium, les silices, les zéolithes, ainsi que les mélanges de deux ou davantage des substances précédentes ; et le matériau piégeur inorganique se présente sous forme particulaire dans la couche B et est partiellement entouré par un matériau de matrice.

2. Bande adhésive selon la revendication 1, **caractérisée en ce que** le matériau de matrice est une masse polymère.

3. Bande adhésive selon au moins l'une quelconque des revendications précédentes, **caractérisée en ce que** le matériau piégeur inorganique est choisi dans le groupe constitué par le sulfate de calcium, le chlorure de calcium, l'oxyde de calcium, les silices pyrogénées, les zéolithes, ainsi que les mélanges de deux ou davantage des substances précédentes.

4. Bande adhésive selon au moins l'une quelconque des revendications précédentes, **caractérisée en ce que** la couche de masse adhésive A et la couche de masse adhésive C présentent chacune un taux de perméation de vapeur d'eau (par rapport à une épaisseur de la masse adhésive de 50 µm et mesuré à 38 °C et 90 % d'humidité relative de l'air selon ASTM F-1249) de moins de 50 g/(m²*d).

5. Bande adhésive selon au moins l'une quelconque des revendications précédentes, **caractérisée en ce que** la bande adhésive contient en plus des couches A, B et C une couche de support supplémentaire, qui ne contient pas de matériau piégeur et est agencée entre les couches A et C.

6. Bande adhésive selon au moins l'une quelconque des revendications précédentes, **caractérisée en ce que** la bande adhésive contient en plus des couches A, B et C au moins une couche de support et au moins une couche de barrière contre un ou plusieurs perméats, la couche de barrière et la couche de support se présentant sous la forme de couches directement successives, qui sont agencées entre les couches A et C.

7. Utilisation d'une bande adhésive selon l'une quelconque des revendications précédentes en tant que matériau d'encapsulation.
